# EUROPEAN PATENT APPLICATION

(11) **EP 3 579 293 A1**
(43) Date of publication of application: **11.12.2019**
(21) Application number: 18748172.6
(22) Date of filing: 02.02.2018
(51) Int. Cl.: H01L 51/50, C08G 61/12, G02F 1/13357, G09F 9/30, H01L 27/32, H05B 33/02

(54) **ORGANIC ELECTRONICS MATERIAL AND USE THEREOF**

(30) Priority: 03.02.2017 JP 2017018572
(71) Applicant: Hitachi Chemical Company, Ltd., Chiyoda-ku Tokyo 100-6606 (JP)
(72) Inventor: SUGIOKA Tomotsugu, Tokyo 100-6606 (JP); ISHITSUKA Kenichi, Tokyo 100-6606 (JP); YOSHINARI Yuki, Tokyo 100-6606 (JP); HONNA Ryo, Tokyo 100-6606 (JP); SAKUMA Hirotaka, Tokyo 100-6606 (JP)
(74) Representative: Beckmann, Claus
(86) International application number: PCT/JP2018/003694
(87) International publication number: WO 2018/143438

(57) **Abstract**

A charge transport material which can be used for an organic electronic element and contains a charge transport polymer capable of improving the element characteristics is provided, and an ink composition containing the material is also provided. Further, an organic electronic element and an organic EL element having excellent element characteristics, and a display element, an illumination device and a display device that use these elements are also provided. More specifically, an organic electronic material containing a charge transport polymer or oligomer having at least one structural unit containing a substituted or unsubstituted dibenzofuran structure or dibenzothiophene structure is provided.

## Description

### TECHNICAL FIELD

Embodiments of the present invention relate to an organic electronic material, an ink composition, an organic layer, an organic electronic element, an organic electroluminescent element (also referred to as an "organic EL element"), a display element, an illumination device, and a display device.

### BACKGROUND ART

Organic EL elements are attracting attention for potential use in large-surface area solid state lighting applications to replace incandescent lamps and gas-filled lamps and the like. Further, organic EL elements are also attracting attention as the leading self-luminous display for replacing liquid crystal displays (LCD) in the field of flat panel displays (FPD), and commercial products are becoming increasingly available.

Depending on the organic material used, organic EL elements can be broadly classified into two types: low-molecular weight type organic EL elements that use a low-molecular weight compound, and polymer type organic EL elements that use a polymer compound. The production methods for organic EL elements are broadly classified into dry processes in which film formation is mainly performed in a vacuum system, and wet processes in which film formation is performed by plate-based printing such as relief printing or intaglio printing, or by plateless printing such as inkjet printing. Because wet processes enable simple film formation, they are expected to be an indispensable method in the production of future large-screen organic EL displays (for example, see Patent Document 1 and Non-Patent Document 1). On the other hand, in recent years, investigations have been conducted into improving the characteristics of elements by using compounds having a dibenzofuran structure or dibenzothiophene structure (Patent Documents 2 to 4). However, the compounds having a dibenzofuran structure or dibenzothiophene structure disclosed in Patent Documents 2 to 4 all have low molecular weights, and therefore film formation using a wet process is problematic.

### CITATION LIST

### PATENT DOCUMENTS

Patent Document 1: JP 2006-279007 A
Patent Document 2: JP 2013-40105 A
Patent Document 3: JP 2015-205860 A
Patent Document 4: JP 2016-861142 A

### NON-PATENT DOCUMENT

Non-Patent Document 1: Kengo Hirose, Daisuke Kumaki, Nobuaki Koike, Akira Kuriyama, Seiichiro Ikehata, and Shizuo Tokito, 53rd Meeting of the Japan Society of Applied Physics and Related Societies, 26p-ZK-4 (2006)

### SUMMARY OF INVENTION

### TECHNICAL PROBLEM

Organic EL elements produced using wet processes have the advantages of facilitating cost reductions and increases in the element surface area. However, in terms of the characteristics of the organic EL elements, organic EL elements containing an organic layer produced using a wet process still require further improvement.

One embodiment of the present invention provides, in light of the above circumstances, an organic electronic material and an ink composition that are suited to wet processes, and are suitable for improving the lifespan characteristics of organic electronic elements. Other embodiments of the present invention provide an organic layer that is suitable for reducing the drive voltage and improving the lifespan characteristics of an organic electronic element, and also provide an organic electronic element, an organic EL element, a display element, an illumination device and a display device that exhibit reduced drive voltages and excellent lifespan characteristics.

### SOLUTION TO PROBLEM

As a result of intensive investigation, the inventors of the present invention has discovered that a charge transport polymer containing a specific structural unit having a dibenzofuran structure or dibenzothiophene structure is suitable as a charge transport material for forming an organic layer of an organic electronic element, and they have therefore completed the present invention.

One embodiment of the present invention provides an organic electronic material containing a charge transport polymer or oligomer having at least one structural unit containing a substituted or unsubstituted dibenzofuran structure or dibenzothiophene structure. The structural unit containing a substituted or unsubstituted dibenzofuran structure or dibenzothiophene structure may be a monovalent structural unit, a divalent structural unit, or a trivalent or higher valent structural unit.

In one embodiment of the present invention, the charge transport polymer or oligomer may have a monovalent structural unit represented by formula (1), having a substituted or unsubstituted dibenzofuran structure or dibenzothiophene structure. One embodiment of the present invention provides an organic electronic material containing a charge transport polymer or oligomer having a monovalent structural unit represented by formula (1) at at least one terminal.

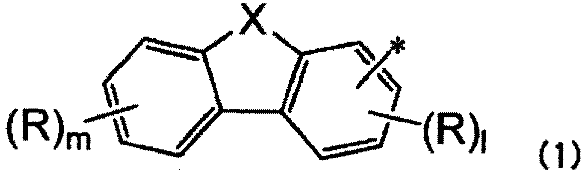

In formula (1), X represents an oxygen atom or a sulfur atom. Each R independently represents a substituent. Further, 1 represents an integer of 0 to 3, and m represents an integer of 0 to 4. In formula (1), "*" indicates a bonding site with another structural unit.

The charge transport polymer or oligomer may have three or more terminals. In this case, the charge transport polymer or oligomer may have a structural unit represented by the above formula (1) at 25% or more of the terminals based on the total number of terminals.

The charge transport polymer or oligomer may be a copolymer of a monomer containing a structural unit having hole transport properties, and a monomer containing a structural unit represented by the formula (1).

The charge transport polymer or oligomer may have a polymerizable substituent.

In one embodiment of the present invention, the charge transport polymer or oligomer may have at least one structural unit selected from the group consisting of a divalent structural unit L1 having a substituted or unsubstituted dibenzofuran structure or dibenzothiophene structure.

The divalent structural unit L1 preferably has at least one structure selected from among a structure represented by formula L1a, a structure represented by formula L1b and a structure represented by formula L1c shown below.

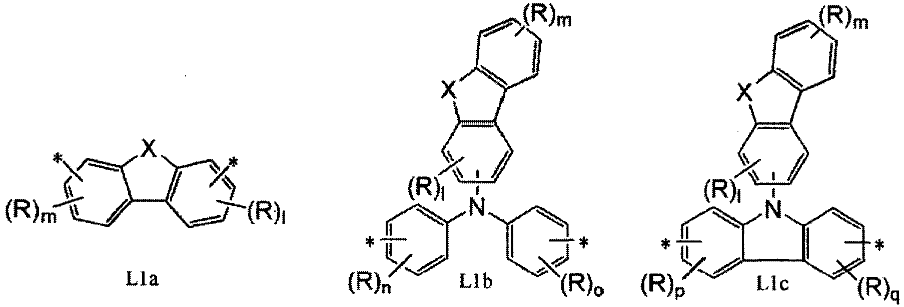

[In the above formulas, X represents an oxygen atom or a sulfur atom. Each R independently represents a hydrogen atom or a substituent. Each R is independently selected from the group consisting of -R¹, -OR², -SR³, -OCOR⁴, -COOR⁵, -SiR⁶R⁷R⁸, a halogen atom, and a group containing a polymerizable functional group described below. Each of R¹ to R⁸ independently represents a hydrogen atom, a linear, cyclic or branched alkyl group, alkenyl group, alkynyl group or alkoxy group of 1 to 22 carbon atoms, an aryl group or heteroaryl group of 2 to 30 carbon atoms, or a polymerizable functional group. Each of 1, m, p and q independently represents an integer of 0 to 3, and each of n and o independently represents an integer of 0 to 4. Further, "*" in formula (1) indicates a bonding site with another structural unit.]

The charge transport polymer described above preferably also has at least one selected from the group consisting of a divalent structural unit L2 that does not contain a dibenzofuran structure or dibenzothiophene structure.

The charge transport polymer preferably also has a divalent structural unit L2 that does not contain a dibenzofuran structure or dibenzothiophene structure, wherein the divalent structural unit L2 preferably contains a structure selected from the group consisting of an aromatic amine structure, a carbazole structure, a thiophene structure, a bithiophene structure, a benzene structure and a fluorene structure.

The charge transport polymer described above preferably has a structure that is branched in three or more directions.

The charge transport polymer preferably has a polymerizable substituent.

Another embodiment of the present invention provides an ink composition containing the organic electronic material of an embodiment described above, and a solvent.

Yet another embodiment of the present invention provides an organic layer formed using the organic electronic material of an embodiment described above, or the ink composition described above.

Another embodiment of the present invention provides an organic electronic element containing at least one of the organic layer of the embodiment described above.

Yet another embodiment of the present invention provides an organic electroluminescent element containing at least one of the organic layer of the embodiment described above.

Another embodiment of the present invention provides an organic electroluminescent element of the embodiment described above that also includes a flexible substrate.

Yet another embodiment of the present invention provides an organic electroluminescent element of the embodiment described above that also includes s a resin film substrate.

Another embodiment of the present invention provides a display element including the organic electroluminescent element of an embodiment described above.

Yet another embodiment of the present invention provides an illumination device including the organic electroluminescent element of an embodiment described above.

Yet another embodiment of the present invention provides a display device including the illumination device of the embodiment described above, and a liquid crystal element as a display unit.

### ADVANTAGEOUS EFFECTS OF THE INVENTION

The organic electronic material and the ink composition according to embodiments of the present invention are suited to wet processes, and are suitable for reducing the drive voltage and improving the lifespan characteristics of organic electronic elements. Further, an organic layer of another embodiment of the present invention is suitable for reducing the drive voltage and improving the lifespan characteristics of an organic electronic element. Moreover, an organic electronic element, an organic EL element, a display element, an illumination device and a display device according to other embodiments of the present invention exhibit reduced drive voltages and excellent lifespan characteristics.

### BRIEF DESCRIPTION OF DRAWINGS

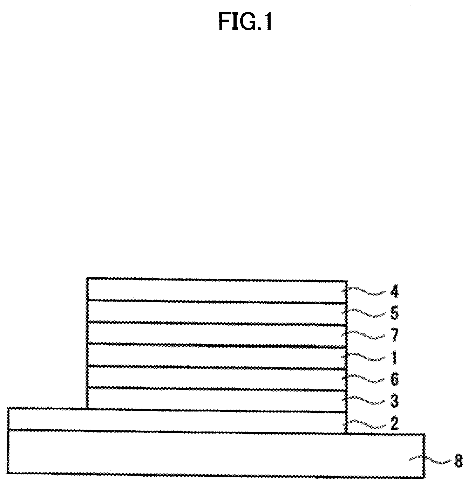

FIG. 1 is a cross-sectional schematic view illustrating one example of an organic EL element according to an embodiment of the present invention.

### DESCRIPTION OF EMBODIMENTS

Embodiments of the present invention are described below, but the present invention is not limited to these embodiments.

### <Organic Electronic Material>

An organic electronic material of an embodiment of the present invention contains a charge transport polymer or oligomer having at least one structural unit containing a dibenzofuran structure or dibenzothiophene structure. This organic electronic material may contain only one type of charge transport polymer or oligomer, or may contain two or more types. Compared with low-molecular weight compounds, a charge transport polymer or oligomer is preferred in terms of offering excellent film formability in wet processes. The above structural unit containing a substituted or unsubstituted dibenzofuran structure or dibenzothiophene structure may be a monovalent structural unit, a divalent structural unit, or a trivalent or higher structural unit.

### [Charge Transport Polymer or Oligomer]

### (Structure of Charge Transport Polymer)

The charge transport polymer or oligomer (in the following description, the charge transport polymer or oligomer is sometimes referred to as simply "the charge transport polymer") is a polymer or oligomer that has the ability to transport an electric charge. The charge transport polymer may be linear, or may have a branched structure. The charge transport polymer preferably contains at least a divalent structural unit L having charge transport properties and a monovalent structural unit T that forms the terminal portions, and may also contain a trivalent or higher structural unit B that forms a branched portion. The charge transport polymer may contain only one type or a plurality of types of each of these structural units. In the charge transport polymer, the structural units are bonded together at "monovalent" to "trivalent or higher valent" bonding sites.

Examples of partial structures contained in the charge transport polymer include those shown below. However, the charge transport polymer is not limited to polymers having the following partial structures. In the partial structures, "L" represents a structural unit L, "T" represents a structural unit T, and "B" represents a structural unit B. The symbol "*" in the formulas in the present description denotes a bonding site with another structural unit. In the following partial structures, the plurality of L structural units may be structural units having the same structure or structural units having mutually different structures. This also applies for the T and B structural units. The charge transport polymer is not limited to polymers having the following partial structure.

Linear Charge Transport Polymers

T-L-L-L-L-L-*

Charge Transport Polymers having Branched Structure

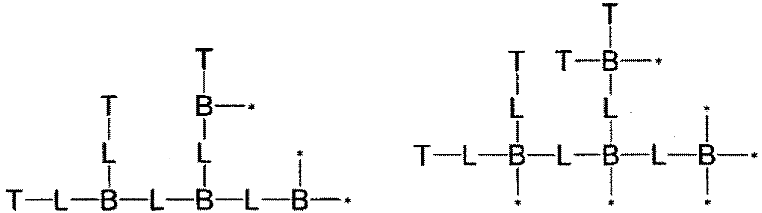

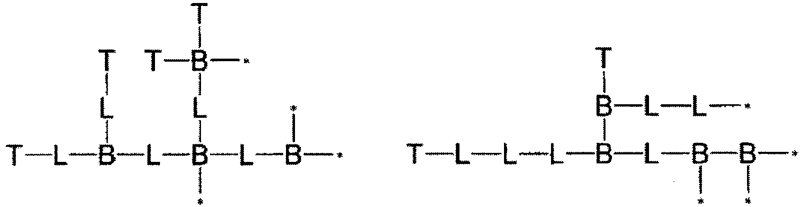

Although described below in further detail, the charge transport polymer of the present embodiment contains at least one structural unit containing a substituted or unsubstituted dibenzofuran structure or dibenzothiophene structure. In other words, at least a portion of "the monovalent structural units T that form the terminal portions", "the divalent structural units L" and "the trivalent or higher structural units B" is a structural unit (or structural units) containing a dibenzofuran structure or dibenzothiophene structure.

In one embodiment, the charge transport polymer contains a structural unit represented by formula (1) at at least one polymer terminal. In other words, at least one of the aforementioned "monovalent structural units T that forms the terminal portions" is a structural unit represented by the above formula (1) (hereafter, this structural unit is also referred to as "the structural unit T1''). This structural unit T1 represented by formula (1) may also exist at a portion other than a polymer terminal, and may be included as a substituent of an aforementioned "divalent structural unit L" and/or "trivalent or higher structural unit B".

In one embodiment of the present invention, the "divalent structural unit L" that constitutes part of the charge transport polymer may have at least one structural unit selected from the group consisting of divalent structural units L1 having a substituted or unsubstituted dibenzofuran structure or dibenzothiophene structure. In this embodiment, as described below in further detail, the divalent structural unit L1 preferably includes a structural unit having at least one structure selected from among structures represented by formulas (L1a, L1b and L1c). This structural unit containing a dibenzofuran structure or dibenzothiophene structure may also exist at a portion other than a divalent structural unit, and may be included as a substituent of an aforementioned "monovalent structural unit T" and/or "trivalent or higher structural unit B".

### (Structural Unit T)

The structural unit T is a monovalent structural unit that constitutes a terminal portion of the charge transport polymer. The charge transport polymer preferably has three or more structural units T. Examples of the structural unit T include monovalent structural units having an aforementioned substituted or unsubstituted dibenzofuran structure or dibenzothiophene structure (hereafter, these structural units are also referred to as "the structural unit T1'') and monovalent structural units that do not have a substituted or unsubstituted dibenzofuran structure or dibenzothiophene structure (hereafter, these structural units are also referred to as "the structural unit T2").

### (Structural Unit T1)

As described above, in one embodiment of the present invention, at least one structural unit T is a structural unit represented by formula (1) (namely, a structural unit T1). The charge transport polymer may have only one type of the structural unit T1, or may have two or more types of the structural unit T1. In those cases where the charge transport polymer has a polymerizable functional group at a terminal portion, in the structural unit T1, at least one R in formula (1) may be a group containing the polymerizable functional group.

### (Structural Unit Represented by Formula (1))

Next is a description of the structural unit represented by formula (1).

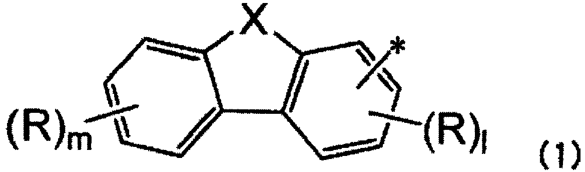

In formula (1) above, X represents an oxygen atom or a sulfur atom. Each R independently represents a substituent. It is preferable that each R is independently selected from the group consisting of -R¹, -OR², -SR³, -OCOR⁴, -COOR⁵, -SiR⁶R⁷R⁸, halogen atoms, and a group containing a polymerizable functional group described below.

R¹ represents at least one selected from the group consisting of a linear, cyclic or branched alkyl group, alkenyl group, alkynyl group or alkoxy group of 1 to 22 carbon atoms, and an aryl group or heteroaryl group of 2 to 30 carbon atoms.

Each of R² to R⁸ independently represents a hydrogen atom, or at least one selected from the group consisting of a linear, cyclic or branched alkyl group, alkenyl group, alkynyl group or alkoxy group of 1 to 22 carbon atoms, and an aryl group or heteroaryl group of 2 to 30 carbon atoms. The aryl groups and heteroaryl groups may further have a substituent. R is preferably a linear, cyclic or branched alkyl group 1 to 22 carbon atoms or a heteroaryl group. Examples of the heteroaryl group include groups containing a carbazole structure, and a specific example of these groups containing a carbazole structure is a 9-carbazolyl group.

In those cases where the aryl group or heteroaryl group further has a substituent, examples of the substituent include those groups listed above as examples of the substituent represented by R in formula (1), and preferred substituents are also the same as described above. In those cases where the charge transport polymer has a polymerizable functional group at a terminal portion, at least one R group may be a group containing a polymerizable functional group. When a plurality of R groups exist, the plurality of R groups may be the same or different.

Further, 1 represents an integer of 0 to 3, and m represents an integer of 0 to 4. Furthermore, "*" in formula (1) indicates a bonding site with another structural unit.

In the present description, an aryl group is an atom grouping in which one hydrogen atom has been removed from an aromatic hydrocarbon. A heteroaryl group is an atom grouping in which one hydrogen atom has been removed from an aromatic heterocycle.

Examples of the aromatic hydrocarbon include monocyclic rings, condensed rings, and polycyclic rings in which two or more rings selected from among monocyclic rings and condensed rings are bonded together via a single bond (single bonds). Examples of the aromatic heterocycles include monocyclic rings, condensed rings, and polycyclic rings in which two or more rings selected from among monocyclic rings and condensed rings are bonded together via a single bond (single bonds).

Specific examples of preferred structural units represented by formula (1) are shown below. However, the structural unit represented by formula (1) is not limited to structures represented by the following formulas. In the following formulas, R is the same as R described above in formula (1).

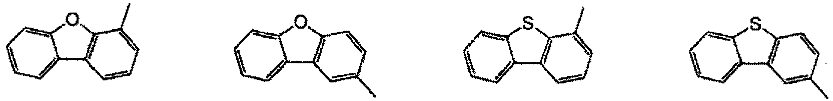

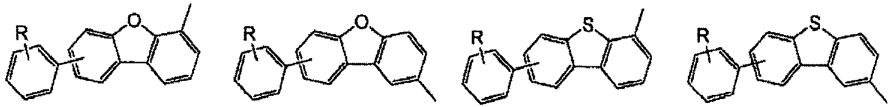

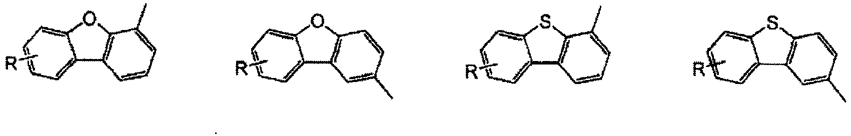

It is thought that the hole transport properties can be improved when the charge transport polymer or oligomer has a structural unit represented by formula (1) at at least one terminal. In particular, it is thought that when the charge transport polymer or oligomer has a structural unit having hole transport properties and a structural unit represented by formula (1) at a terminal, the π-conjugated system in the charge transport polymer or oligomer is expanded and superior hole transport capabilities are achieved, meaning the charge transport polymer or oligomer is able to exhibit superior performance as an organic electronic material.

### (Structural Unit T2)

In one embodiment, in addition to the structural unit T1 described above, the charge transport polymer may also have a structural unit other than the structural unit T1, that is, a structural unit that does not have a structure represented by formula (1) (namely, the structural unit T2), as a terminal structural unit T. The charge transport polymer may have only one type of the structural unit T2, or may have two or more types of the structural unit T2.

There are no particular limitations on the structural unit T2 which may be selected, for example, from among substituted or unsubstituted aromatic hydrocarbon structures and aromatic heterocyclic structures, and structures containing one type, or two or more types, of these structures. In one embodiment, from the viewpoint of imparting durability without impairing the charge transport properties, the structural unit T2 is preferably a substituted or unsubstituted aromatic hydrocarbon structure, and is more preferably a substituted or unsubstituted benzene structure. Further, in another embodiment, as described below, in the case where the charge transport polymer has a polymerizable functional group at a terminal portion, the structural unit T2 may be a polymerizable structure (for example, a polymerizable functional group such as a pyrrolyl group), or may have a polymerizable functional group. With the exception of the different valence, the structural unit T2 may have the same structure as the structural unit L2 and/or the structural unit B, or may have a different structure.

Specific examples of the structural unit T2 are shown below. The structural unit T2 is not limited to the following structure.

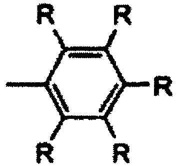

In the above formula, R is the same as R in the structural unit L2 (but excluding the cases where the heteroaryl group includes a structure of the formula (1)). In those cases where the charge transport polymer has a polymerizable functional group at a terminal portion, at least one R group is preferably a group containing the polymerizable functional group.

From the viewpoint of improving the characteristics of organic electronic elements, the proportion of the structural unit T1 among all of the terminals in the charge transport polymer, based on the total number of all the terminals, is preferably at least 25%, more preferably at least 30%, and even more preferably 35% or greater. There are no particular limitations on the upper limit, which may be any number of 100% or less. This proportion among all of the terminals can be determined from the ratio (molar ratio) between the amounts added of the monomers corresponding with the terminal structural units used during the synthesis of the charge transport polymer.

In those cases where the charge transport polymer has a structural unit T2, from the viewpoint of improving the characteristics of organic electronic elements, the proportion of the structural unit T2 among all of the terminals, based on the total number of all of the terminals, is preferably not more than 75%, more preferably not more than 70%, and even more preferably 65% or less. There are no particular limitations on the lower limit, but if consideration is given to factors such as the introduction of a polymerizable substituent described below, and the introduction of substituents for the purposes of improving the film formability and the wetting properties and the like, the lower limit may be typically at least 5%.

### (Structural Unit L)

The structural unit L is a divalent structural unit having charge transport properties. Examples of the structural unit L include divalent structural units having an aforementioned substituted or unsubstituted dibenzofuran structure or dibenzothiophene structure (hereafter, these structural units are also referred to as "the structural unit L1'') and divalent structural units that do not have a substituted or unsubstituted dibenzofuran structure or dibenzothiophene structure (hereafter, these structural units are also referred to as "the structural unit L2").

In one embodiment, the charge transport polymer preferably contains the structural unit L1 containing a dibenzofuran structure or dibenzothiophene structure. A more detailed description of each structural unit is provided below.

### (Structural Unit L1)

In one embodiment, the structural unit L1 is an organic group having a dibenzofuran structure or dibenzothiophene structure. Examples of the structural unit L1 include Lla, L1b and L1c shown below, but the structural unit L1 is not limited to the following structures.

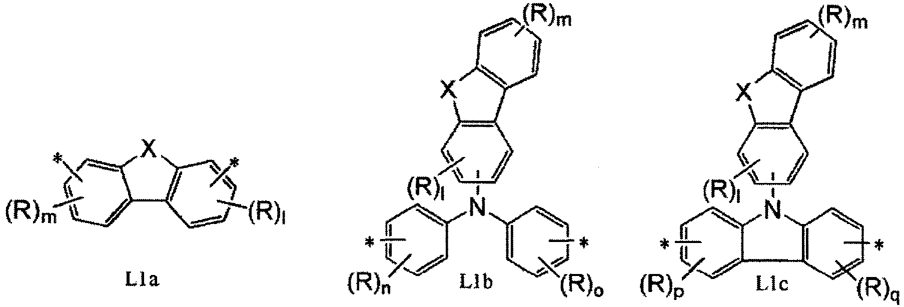

Each R independently represents a hydrogen atom or a substituent. It is preferable that each R is independently selected from the group consisting of -R¹, -OR², -SR³, -OCOR⁴, -COOR⁵, -SiR⁶R⁷R⁸, a halogen atom, and a group containing a polymerizable functional group described below. Each of R¹ to R⁸ independently represents a hydrogen atom, or at least one selected from the group consisting of a linear, cyclic or branched alkyl group, alkenyl groups, alkynyl group or alkoxy group of 1 to 22 carbon atoms, and an aryl group or heteroaryl group of 2 to 30 carbon atoms. The aryl groups and heteroaryl groups may also have a substituent. R is preferably a linear, cyclic or branched alkyl group of 1 to 22 carbon atoms, a heteroaryl group, or a hydrogen atom. In those cases where the charge transport polymer has a polymerizable functional group at a terminal portion, at least one R group may be a group containing a polymerizable functional group. Each of 1, m, p and q independently represents an integer of 0 to 3, and each of n and o independently represents an integer of 0 to 4. Further, "*" in the formulas indicates a bonding site with another structural unit.

Specific examples of preferred structural units L1 are shown below. However, the structural unit L1 is not limited to the following structures.

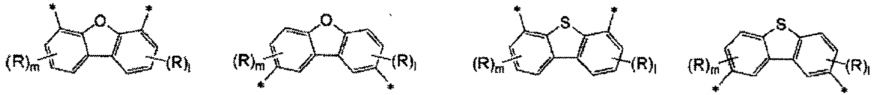

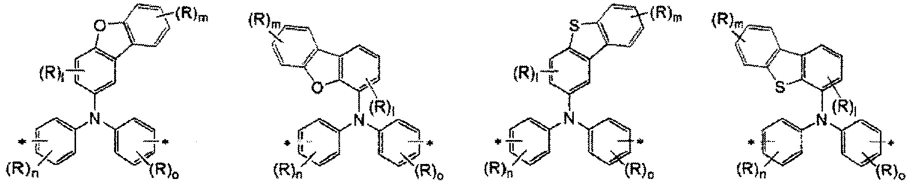

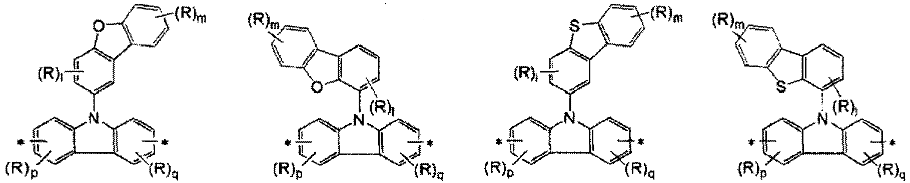

It is thought that the hole transport properties can be improved when the charge transport polymer or oligomer has a divalent structural unit L1 described above. In particular, it is thought that when the charge transport polymer or oligomer has another structural unit having hole transport properties and the divalent structural unit L1, the π-conjugated system in the charge transport polymer or oligomer is expanded and superior hole transport capabilities are achieved, meaning the charge transport polymer or oligomer is able to exhibit superior performance as an organic electronic material.

### (Structural Unit L2)

The structural unit L2 refers to a divalent structural unit having charge transport properties that does not include a structural unit having a dibenzofuran structure or dibenzothiophene structure. There are no particular limitations on the structural unit L2, provided it contains an atom grouping that has the ability to transport an electric charge. For example, the structural unit L2 may be selected from among substituted or unsubstituted aromatic amine structures, substituted or unsubstituted carbazole structures, substituted or unsubstituted thiophene structures, substituted or unsubstituted fluorene structures, substituted or unsubstituted benzene structures, substituted or unsubstituted biphenylene structures, substituted or unsubstituted terphenylene structures, substituted or unsubstituted naphthalene structures, substituted or unsubstituted anthracene structures, substituted or unsubstituted tetracene structures, substituted or unsubstituted phenanthrene structures, substituted or unsubstituted dihydrophenanthrene structures, substituted or unsubstituted pyridine structures, substituted or unsubstituted pyrazine structures, substituted or unsubstituted quinoline structures, substituted or unsubstituted isoquinoline structures, substituted or unsubstituted quinoxaline structures, substituted or unsubstituted acridine structures, substituted or unsubstituted diazaphenanthrene structures, substituted or unsubstituted furan structures, substituted or unsubstituted pyrrole structures, substituted or unsubstituted oxazole structures, substituted or unsubstituted oxadiazole structures, substituted or unsubstituted thiazole structures, substituted or unsubstituted thiadiazole structures, substituted or unsubstituted triazole structures, substituted or unsubstituted benzothiophene structures, substituted or unsubstituted benzoxazole structures, substituted or unsubstituted benzoxadiazole structures, substituted or unsubstituted benzothiazole structures, substituted or unsubstituted benzothiadiazole structures, substituted or unsubstituted benzotriazole structures, and structures containing one type, or two or more types, of the above structures. The aromatic amine structure that does not contain a structural unit represented by formula (1) are preferably a triarylamine structure, and more preferably a triphenylamine structure.

In one embodiment, from the viewpoint of obtaining superior hole transport properties, the structural unit L2 is preferably selected from among substituted or unsubstituted aromatic amine structures, substituted or unsubstituted carbazole structures, substituted or unsubstituted thiophene structures, substituted or unsubstituted fluorene structures, substituted or unsubstituted benzene structures, substituted or unsubstituted pyrrole structures, and structures containing one type, or two or more types, of these structures. The structural unit L2 is more preferably selected from among substituted or unsubstituted aromatic amine structures, substituted or unsubstituted carbazole structures, and structures containing one type, or two or more types, of these structures. In another embodiment, from the viewpoint of obtaining superior electron transport properties, the structural unit L2 is preferably selected from among substituted or unsubstituted fluorene structures, substituted or unsubstituted benzene structures, substituted or unsubstituted phenanthrene structures, substituted or unsubstituted pyridine structures, substituted or unsubstituted quinoline structures, and structures containing one type, or two or more types, of these structures.

Specific examples of the structural unit L2 are shown below. However, the structural unit L2 is not limited to the following structures.

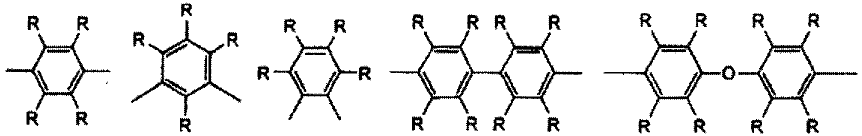

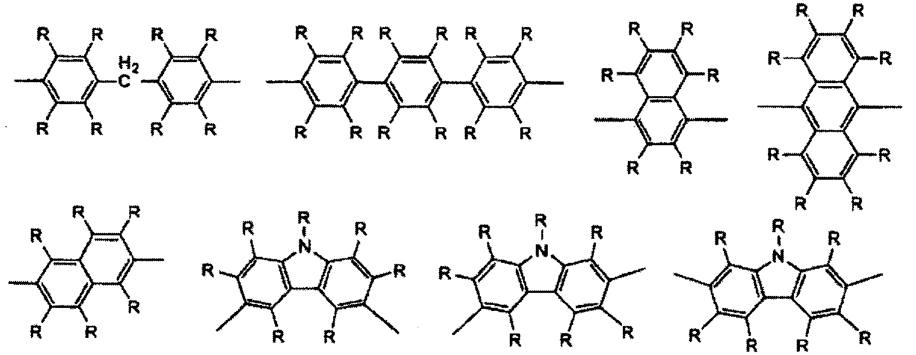

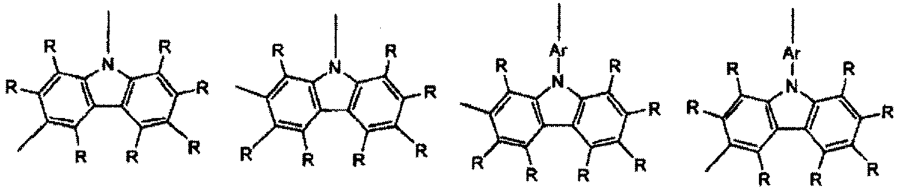

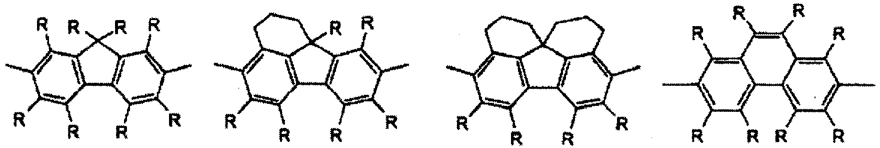

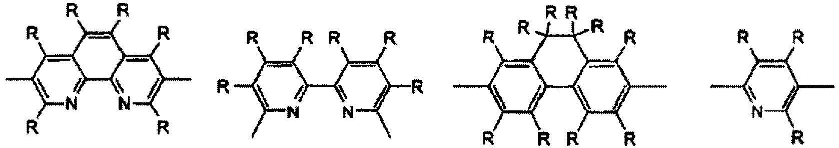

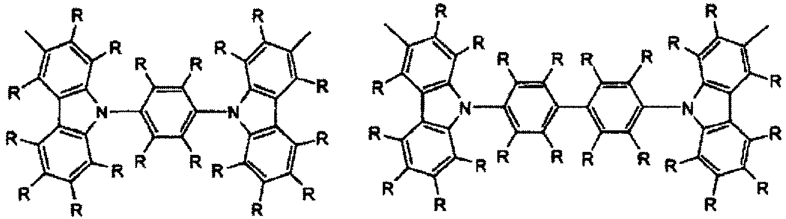

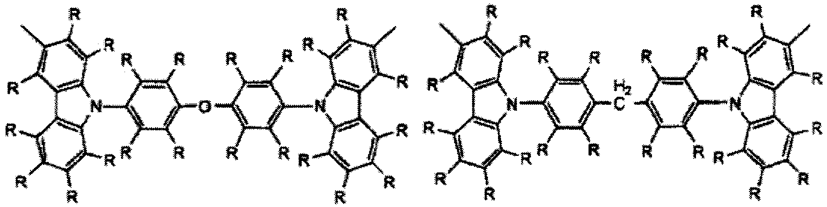

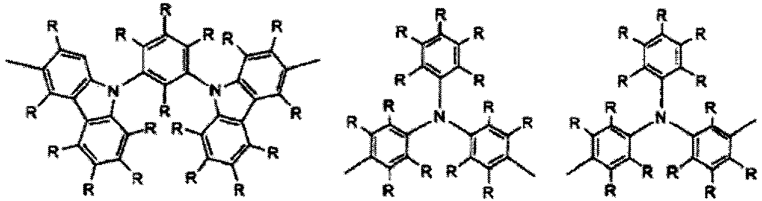

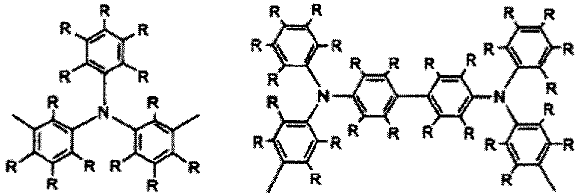

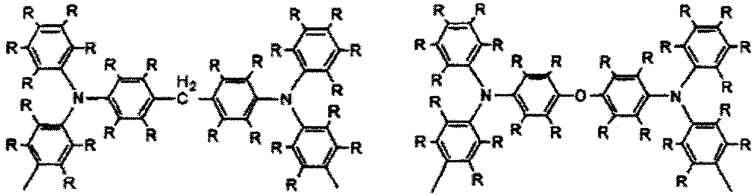

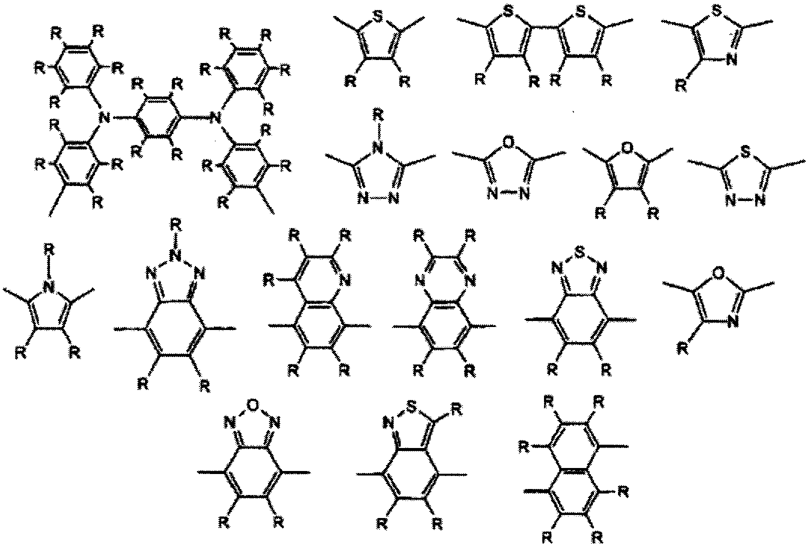

In the above formulas, each R independently represents a hydrogen atom or a substituent. It is preferable that each R is independently selected from the group consisting of -R¹, -OR², -SR³, - OCOR⁴, -COOR⁵, -SiR⁶R⁷R⁸, a halogen atoms, and a group containing a polymerizable functional group described below.

Each of R¹ to R⁸ independently represents a hydrogen atom, a linear, cyclic or branched alkyl group of 1 to 22 carbon atoms, or an aryl group or heteroaryl group of 2 to 30 carbon atoms. An aryl group is an atom grouping in which one hydrogen atom has been removed from an aromatic hydrocarbon. A heteroaryl group is an atom grouping in which one hydrogen atom has been removed from an aromatic heterocycle. The alkyl group may be further substituted with an aryl group or heteroaryl group of 2 to 20 carbon atoms, and the aryl group or heteroaryl group may be further substituted with a linear, cyclic or branched alkyl group of 1 to 22 carbon atoms.

R is preferably a hydrogen atom, an alkyl group, an aryl group, or an alkyl-substituted aryl group.

Ar represents an arylene group or heteroarylene group of 2 to 30 carbon atoms. Ar is preferably an arylene group, and is more preferably a phenylene group. A heteroarylene group is an atom grouping in which two hydrogen atoms have been removed from an aromatic heterocycle. Ar is preferably an arylene group, and is more preferably a phenylene group.

Examples of the aromatic hydrocarbon include monocyclic rings, condensed rings, and polycyclic rings in which two or more rings selected from among monocyclic rings and condensed rings are bonded together via a single bond (single bonds). Examples of the aromatic heterocycles include monocyclic rings, condensed rings, and polycyclic rings in which two or more rings selected from among monocyclic rings and condensed rings are bonded together via a single bond (single bonds).

### (Structural Unit B)

The structural unit B is a trivalent or higher valent structural unit that forms a branched portion in those cases where the charge transport polymer has a branched structure. From the viewpoint of improving the durability of organic electronic elements, the structural unit B is preferably not higher than hexavalent, and is more preferably either trivalent or tetravalent. The structural unit B is preferably a unit that has charge transport properties. For example, from the viewpoint of improving the durability of organic electronic elements, the structural unit B is preferably selected from among substituted or unsubstituted aromatic amine structures, substituted or unsubstituted carbazole structures, substituted or unsubstituted condensed polycyclic aromatic hydrocarbon structures, and structures containing one type, or two or more types, of these structures. The structural unit B may have the same structure as the structural unit L2 or a different structure, and may have the same structure as the structural unit T2 or a different structure.

Specific examples of the structural unit B are shown below. However, the structural unit B is not limited to the following structures.

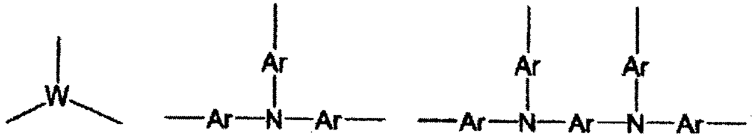

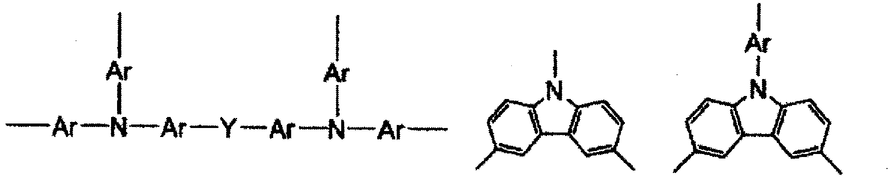

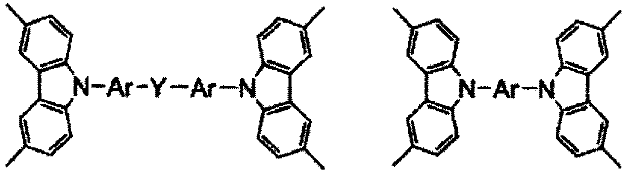

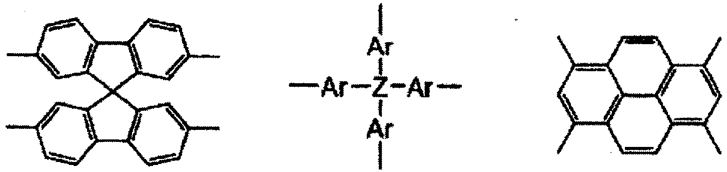

W represents a trivalent linking group, and, may be, for example, represent an arenetriyl group or heteroarenetriyl group of 2 to 30 carbon atoms. As mentioned above, an arenetriyl group is an atom grouping in which three hydrogen atoms have been removed from an aromatic hydrocarbon. A heteroarenetriyl group is an atom grouping in which three hydrogen atoms have been removed from an aromatic heterocycle. Each Ar independently represents a divalent linking group, and for example, may represent an arylene group or heteroarylene group of 2 to 30 carbon atoms.

Ar is preferably an arylene group, and is more preferably a phenylene group. Y represents a divalent linking group, and examples thereof include divalent groups in which an additional hydrogen atom has been removed from any of the R groups having one or more hydrogen atoms (but excluding groups containing a polymerizable functional group) described above in relation to the structural unit L.

Z represents a carbon atom, a silicon atom or a phosphorus atom. In the structural unit B, the benzene rings and Ar groups may have a substituent, and examples of the substituent include the R groups in the structural unit L2. In the structural unit B, W, the benzene rings and the Ar groups may have a structure represented by formula (1) as a substituent.

In one embodiment, the trivalent or higher valent structural unit B constituting part of the charge transport polymer preferably has a structure that is branched in three or more directions. A "structure that is branched in three or more directions" means that among the various chains within a single molecule of the charge transport polymer, if the chain that has the highest degree of polymerization is deemed the main chain, then one or more side chains having a degree of polymerization that is either the same as, or smaller than, that of the main chain also exist in the molecule. In the present invention, the above "degree of polymerization" represents the number of monomer units of the monomer used in synthesizing the charge transport polymer that are contained within one molecule of the charge transport polymer. Further, in this description, a "side chain" means a chain that is different from the main chain of the charge transport polymer and has at least one structural unit, whereas other moieties outside of this definition are deemed substituents.

### (Polymerizable Functional Group)

In one embodiment, from the viewpoint of enabling the polymer to be cured by a polymerization reaction, thereby changing the degree of solubility in solvents, the charge transport polymer preferably has at least one polymerizable functional group (also referred to as a "polymerizable substituent"). A "polymerizable functional group" refers to a functional group which is able to form bonds upon the application of heat and/or light. The polymerizable functional group may be contained within the structural unit represented by formula (1), or may be contained in a structural unit other than the structural unit represented by formula (1).

Examples of the polymerizable functional group include groups having a carbon-carbon multiple bond (such as a vinyl group, allyl group, butenyl group, ethynyl group, acryloyl group, acryloyloxy group, acryloylamino group, methacryloyl group, methacryloyloxy group, methacryloylamino group, vinyloxy group and vinylamino group), groups having a small ring (examples thereof including cyclic alkyl groups such as a cyclopropyl group and cyclobutyl group; cyclic ether groups such as an epoxy group (oxiranyl group) and oxetane group (oxetanyl group); diketene groups; episulfide groups; lactone groups; and lactam groups), and heterocyclic groups (such as a furanyl group, pyrrolyl group, thiophenyl group and silolyl group). If these groups are substituted, then there are no particular limitations on the substituent, and examples of the substituent include linear, cyclic or branched alkyl groups of 1 to 22 carbon atoms (and preferably 1 to 10 carbon atoms). Substituted or unsubstituted groups having a cyclic ether structure or groups having a carbon-carbon multiple bond or the like are preferred as the polymerizable functional group, a substituted or unsubstituted vinyl group, acryloyl group, methacryloyl group, epoxy group or oxetane group is particularly preferred, and from the viewpoint of the reactivity and the characteristics of organic electronic elements, a substituted or unsubstituted vinyl group, a substituted or unsubstituted oxetane group or a substituted or unsubstituted epoxy group is more preferred, and a substituted or unsubstituted oxetane group is the most desirable.

From the viewpoints of increasing the degree of freedom associated with the polymerizable functional group and facilitating the polymerization reaction, the main skeleton of the charge transport polymer and the polymerizable functional group are preferably linked via an alkylene chain such as a linear alkylene chain of 1 to 8 carbon atoms. Further, in the case where, for example, an organic layer is to be formed on an electrode, from the viewpoint of enhancing the affinity with hydrophilic electrodes of ITO or the like, the main backbone and the polymerizable functional group are preferably linked via a hydrophilic chain such as an ethylene glycol chain or a diethylene glycol chain. From the viewpoint of simplifying preparation of the monomer used for introducing the polymerizable functional group, the charge transport polymer may have an ether linkage or an ester linkage at the terminal of the alkylene chain and/or the hydrophilic chain, namely, at the linkage site between such a chain and the polymerizable functional group, and/or at the linkage site between such a chain and the charge transport polymer backbone. The aforementioned "group containing a polymerizable functional group" means the polymerizable functional group itself, or a group in which the polymerizable functional group and an alkylene chain or the like are combined. Examples of groups that can be used favorably as this group containing a polymerizable functional group include the groups exemplified in WO 2010/140553.

The polymerizable functional group may be introduced at a terminal portion of the charge transport polymer (namely, a structural unit T), at a portion other than a terminal portion (namely, a structural unit L or B), or at both a terminal portion and a portion other than a terminal. From the viewpoint of the curability, the polymerizable functional group is preferably introduced at least at a terminal portion, and from the viewpoint of achieving a combination of favorable curability and charge transport properties, is preferably introduced only at terminal portions. Further, in those cases where the charge transport polymer has a branched structure, the polymerizable functional group may be introduced within the main chain of the charge transport polymer, within a side chain, or within both the main chain and a side chain.

From the viewpoint of contributing to a change in the degree of solubility, the polymerizable functional group is preferably included in the charge transport polymer in a large amount. On the other hand, from the viewpoint of not impeding the charge transport properties, the amount included in the charge transport polymer is preferably kept small. The amount of the polymerizable functional group may be set as appropriate with due consideration of these factors.

For example, from the viewpoint of obtaining a satisfactory change in the degree of solubility, the number of polymerizable functional groups per molecule of the charge transport polymer is preferably at least two, and more preferably three or greater. Further, from the viewpoint of maintaining good charge transport properties, the number of polymerizable functional groups is preferably not more than 1,000, and more preferably 500 or fewer.

The number of polymerizable functional groups per molecule of the charge transport polymer can be determined as an average value using the amount of the polymerizable functional group used in synthesizing the charge transport polymer (for example, the amount added of the monomer having the polymerizable functional group), the amounts added of the monomers corresponding with the various structural units, and the weight average molecular weight of the charge transport polymer and the like. the number of polymerizable functional groups can also be calculated as an average value using the ratio between the integral of the signal attributable to the polymerizable functional group and the integral of the total spectrum in the ¹H-NMR (nuclear magnetic resonance) spectrum of the charge transport polymer, and the weight average molecular weight of the charge transport polymer and the like. In terms of ease of calculation, if the amounts added of the monomers are clear, then the value determined using these amounts added of the monomer is preferably employed.

### (Number Average Molecular Weight)

The number average molecular weight of the charge transport polymer can be adjusted appropriately with due consideration of the solubility in solvents and the film formability and the like. From the viewpoint of ensuring superior charge transport properties, the number average molecular weight is preferably at least 500, more preferably at least 1,000, and even more preferably 2,000 or greater. Further, from the viewpoints of maintaining favorable solubility in solvents and facilitating the preparation of ink compositions, the number average molecular weight is preferably not more than 1,000,000, more preferably not more than 100,000, and even more preferably 50,000 or less.

### (Weight Average Molecular Weight)

The weight average molecular weight of the charge transport polymer can be adjusted appropriately with due consideration of the solubility in solvents and the film formability and the like. From the viewpoint of ensuring superior charge transport properties, the weight average molecular weight is preferably at least 1,000, more preferably at least 5,000, and even more preferably 10,000 or greater. Further, from the viewpoints of maintaining favorable solubility in solvents and facilitating the preparation of ink compositions, the weight average molecular weight is preferably not more than 1,000,000, more preferably not more than 700,000, even more preferably not more than 400,000, and most preferably 300,000 or less.

The number average molecular weight and the weight average molecular weight can be measured by gel permeation chromatography (GPC), using a calibration curve of standard polystyrenes.

### (Proportions of Structural Units)

From the viewpoint of obtaining satisfactory charge transport properties, the proportion of the structural unit L2 contained in the charge transport polymer, based on the total of all the structural units, is preferably at least 10 mol%, more preferably at least 20 mol%, and even more preferably 30 mol% or higher. If the structural unit T and the optionally included structural unit B are taken into consideration, then the proportion of the structural unit L is preferably not more than 95 mol%, more preferably not more than 90 mol%, and even more preferably 85 mol% or less. Furthermore, from the viewpoints of obtaining satisfactory charge transport properties and extending the lifespan of organic EL elements, the proportion of the structural unit L1, based on the total of all the structural units L, is preferably at least 3 mol%, more preferably at least 5 mol%, and even more preferably 7 mol% or greater.

From the viewpoint of improving the characteristics of organic electronic elements, or from the viewpoint of suppressing any increase in viscosity and enabling more favorable synthesis of the charge transport polymer, the proportion of the structural unit T (the total of the structural units T1 and T2) contained in the charge transport polymer, based on the total of all the structural units, is preferably at least 5 mol%, more preferably at least 10 mol%, and even more preferably 15 mol% or higher. Further, from the viewpoint of obtaining satisfactory charge transport properties, the proportion of the structural unit T is preferably not more than 60 mol%, more preferably not more than 55 mol%, and even more preferably 50 mol% or less.

In those cases where the charge transport polymer includes a structural unit B, from the viewpoint of improving the durability of organic electronic elements, the proportion of the structural unit B, based on the total of all the structural units, is preferably at least 1 mol%, more preferably at least 5 mol%, and even more preferably 10 mol% or higher. From the viewpoints of suppressing any increase in viscosity and enabling more favorable synthesis of the charge transport polymer, or from the viewpoint of obtaining satisfactory charge transport properties, the proportion of the structural unit B is preferably not more than 50 mol%, more preferably not more than 40 mol%, and even more preferably 30 mol% or less.

In those cases where the charge transport polymer has a polymerizable functional group, from the viewpoint of ensuring efficient curing of the charge transport polymer, the proportion of the polymerizable functional group, based on the total of all the structural units, is preferably at least 0.1 mol%, more preferably at least 1 mol%, and even more preferably 3 mol% or higher. Further, from the viewpoint of obtaining favorable charge transport properties, the proportion of the polymerizable functional group is preferably not more than 70 mol%, more preferably not more than 60 mol%, and even more preferably 50 mol% or less. Here, the "proportion of the polymerizable functional group" refers to the proportion of structural units having the polymerizable functional group.

Considering the balance between the charge transport properties, the durability and the productivity and the like, the ratio (molar ratio) between the structural unit L and the structural unit T is preferably L:T = 100:(1 to 70), more preferably 100:(3 to 50), and even more preferably 100:(5 to 30). Further, in those cases where the charge transport polymer includes the structural unit B, the ratio (molar ratio) between the structural unit L, the structural unit T and the structural unit B is preferably L:T:B = 100:(10 to 200):(10 to 100), more preferably 100:(20 to 180):(20 to 90), and even more preferably 100:(40 to 160):(30 to 80).

The proportion of each structural unit can be determined from the amount added of the monomer corresponding with that structural unit during synthesis of the charge transport polymer. Further, the proportion of each structural unit can also be calculated as an average value using the integral of the spectrum attributable to the structural unit in the ¹H-NMR spectrum of the charge transport polymer. In terms of ease of calculation, if the amounts added of the monomers are clear, then, for the proportion of the structural unit, the value determined using the amounts added of the monomers is preferably used.

In a preferred embodiment, the charge transport polymer preferably contains at least a structural unit having hole transport properties, and a structural unit T1 and/or L1 represented by formula (1). In a particularly preferred embodiment, from the viewpoints of achieving superior hole injection properties and hole transport properties and the like, the charge transport polymer is preferably a compound containing a structural unit having an aromatic amine structure and/or a structural unit having a carbazole structure as the main structural unit (main skeleton). Further, from the viewpoint of facilitating easier multilayering, the charge transport polymer is preferably a compound having at least two or more polymerizable substituents. In terms of providing superior curability, the polymerizable substituent is preferably, for example, a group having a cyclic ether structure or a group having a carbon-carbon multiple bond or the like.

### (Production Method)

The charge transport polymer of an embodiment of the present invention is preferably a copolymer of monomers including at least a monomer containing a structural unit having hole transport properties and a monomer containing a structural unit represented by formula (1). In other words, the charge transport polymer can be produced favorably by copolymerizing a monomer mixture containing one or more monomers containing the structural unit L2 and one or more monomers containing the structural unit T1 and/or L1, and optionally containing one or more other monomers (such as a monomer containing the structural unit T2 and/or a monomer containing the structural unit B). The copolymer may be an alternating, random, block or graft copolymer, or a copolymer having an intermediate type structure, such as a random copolymer having block-like properties.

The charge transport polymer can be produced by any of various synthesis methods, and there are no particular limitations. For example, known coupling reactions such as the Suzuki coupling, Negishi coupling, Sonogashira coupling, Stille coupling and Buchwald-Hartwig coupling reactions can be used. The Suzuki coupling is a reaction in which a cross-coupling reaction is initiated between an aromatic boronic acid derivative and an aromatic halide using a Pd catalyst. By using a Suzuki coupling, the charge transport polymer can be produced easily by bonding together the desired aromatic rings.

In the coupling reaction, for example, a Pd(0) compound, a Pd(II) compound, or a Ni compound or the like is used as a catalyst. A catalyst species generated by mixing a precursor such as tris(dibenzylideneacetone)dipalladium(0) or palladium(II) acetate with a phosphine ligand can also be used. Reference may also be made to WO 2010/140553 in relation to synthesis methods for the charge transport polymer.

### [Dopant]

The organic electronic material may include any optional additive, and for example, the organic electronic material may include a dopant. There are no particular limitations on the dopant, provided a doping effect is achieved by adding the dopant to the organic electronic material, enabling an improvement in the charge transport properties. With respect to doping, there are p-type doping and n-type doping. In p-type doping, a substance that functions as an electron acceptor is used as the dopant, whereas in n-type doping, a substance that functions as an electron donor is used as the dopant. To improve the hole transport properties, p-type doping is preferably performed, whereas to improve the electron transport properties, n-type doping is preferably performed. The dopant used in the organic electronic material may be a dopant that exhibits either a p-type doping effect or an n-type doping effect. Further, a single dopant may be added alone, or a mixture of a plurality of dopants may be added.

The dopants used in p-type doping are electron-accepting compounds, and examples of the dopants used in p-type doping include Lewis acids, protonic acids, transition metal compounds, ionic compounds, halogen compounds and π-conjugated compounds. Specific examples of the Lewis acid include FeCl₃, PFs, AsFs, SbFs, BF₅, BCl₃ and BBr₃; specific examples of the protonic acid include inorganic acids such as HF, HCl, HBr, HNO₅, H₂SO₄ and HClO₄, and organic acids such as benzenesulfonic acid, p-toluenesulfonic acid, dodecylbenzenesulfonic acid, polyvinylsulfonic acid, methanesulfonic acid, trifluoromethanesulfonic acid, trifluoroacetic acid, 1-butanesulfonic acid, vinylphenylsulfonic acid and camphorsulfonic acid; specific examples of the transition metal compound include FeOCl, TiCl₄, ZrCl₄, HfCl₄, NbF₅, AlCl₃, NbCl₅, TaCl₅ and MoF₅; specific examples of the ionic compound include salts containing a perfluoro anion such as a tetrakis(pentafluorophenyl)borate ion, tris(trifluoromethanesulfonyl)methide ion, bis(trifluoromethanesulfonyl)imide ion, hexafluoroantimonate ion, AsF₆⁻ (hexafluoroarsenate ion), BF₄⁻ (tetrafluoroborate ion) or PF₆⁻ (hexafluorophosphate ion), and salts having a conjugate base of an aforementioned protonic acid as an anion; examples of the halogen compound include Cl₂, Br₂, I₂, ICl, ICl₃, IBr and IF; and π-conjugated compounds such as TCNE (tetracyanoethylene) and TCNQ (tetracyanoquinodimethane). Further, the electron-accepting compounds disclosed in JP 2000-36390 A, JP 2005-75948 A, and JP 2003-213002 A and the like can also be used. Lewis acids, ionic compounds, and π-conjugated compounds and the like are preferred.

The dopants used in n-type doping are electron-donating compounds, and examples of the dopants used in n-type doping include alkali metals such as Li and Cs; alkaline earth metals such as Mg and Ca; salts of alkali metals and/or alkaline earth metals such as LiF and CS₂CO₃; metal complexes; and electron-donating organic compounds.

In those cases where the charge transport polymer has a polymerizable functional group, in order to facilitate a change in the solubility of the organic layer, the use of a compound that can function as a polymerization initiator for the polymerizable functional group as the dopant is preferred.

### [Other Optional Components]

The organic electronic material may also contain a charge transport low-molecular weight compound, and/or another polymer and/or the like.

### [Contents]

From the viewpoint of obtaining favorable charge transport properties, the amount of the charge transport polymer in the organic electronic material, relative to the total mass of the organic electronic material, is preferably at least 50% by mass, more preferably at least 70% by mass, and even more preferably 80% by mass or greater. There are no particular limitations on the upper limit for the amount of the charge transport polymer, and the amount may be 100% by mass. If consideration is given to the inclusion of an additive such as a dopant, then the amount of the charge transport polymer may be typically not more than 95% by mass, or not more than 90% by mass or the like.

When a dopant is included, from the viewpoint of improving the charge transport properties of the organic electronic material, the amount of the dopant relative to the total mass of the organic electronic material is preferably at least 0.01% by mass, more preferably at least 0.1% by mass, and even more preferably 0.5% by mass or greater. Further, from the viewpoint of maintaining favorable film formability, the amount of the dopant relative to the total mass of the organic electronic material is preferably not more than 50% by mass, more preferably not more than 30% by mass, and even more preferably 20% by mass or less.

### <Ink Composition>

An ink composition according to an embodiment of the present invention contains the organic electronic material of the embodiment described above and a solvent that is capable of dissolving or dispersing that material. By using the ink composition, an organic layer can be formed easily via a simple method, such as a coating method.

### [Solvent]

Examples of solvents that may be used include water, organic solvents, and mixed solvents thereof. Examples of the organic solvents include alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amide-based solvents such as N,N-dimethylformamide and N,N-dimethylacetamide; as well as dimethyl sulfoxide, tetrahydrofuran, acetone, chloroform and methylene chloride and the like. Preferred examples of solvents include aromatic hydrocarbons, aliphatic esters, aromatic esters, aliphatic ethers, and aromatic ethers and the like.

### [Polymerization Initiator]

In those cases where the charge transport polymer has a polymerizable functional group, the ink composition preferably contains a polymerization initiator. Any of known radical polymerization initiators, cationic polymerization initiators, and anionic polymerization initiators and the like can be used as the polymerization initiator. From the viewpoint of enabling simple preparation of the ink composition, the use of a substance that exhibits both a function as a dopant and a function as a polymerization initiator is preferred. Examples of such substances include the ionic compounds described above.

### [Additives]

The ink composition may also contain an additive as an optional component. Examples of such an additive include polymerization inhibitors, stabilizers, thickeners, gelling agents, flame retardants, antioxidants, reduction inhibitors, oxidizing agents, reducing agents, surface modifiers, emulsifiers, antifoaming agents, dispersants and surfactants.

### [Contents]

The amount of the solvent in the ink composition can be determined with due consideration of the use of the composition in various application methods. For example, the amount of the solvent is preferably an amount that yields a ratio of the charge transport polymer relative to the solvent that is at least 0.1% by mass, more preferably at least 0.2% by mass, and even more preferably 0.5% by mass or greater. Further, the amount of the solvent is preferably an amount that yields a ratio of the charge transport polymer relative to the solvent that is not more than 20% by mass, more preferably not more than 15% by mass, and even more preferably 10% by mass or less.

### <Organic Layer>

An organic layer according to an embodiment of the present invention is a layer formed using the organic electronic material or the ink composition of embodiments described above. By using the ink composition, the organic layer can be formed easily and favorably by a coating method. Examples of the coating method include known methods such as spin coating methods; casting methods; dipping methods; plate-based printing methods such as relief printing, intaglio printing, offset printing, lithographic printing, relief reversal offset printing, screen printing and gravure printing; and plateless printing methods such as inkjet methods. When the organic layer is formed by a coating method, the organic layer (coating layer) obtained following coating may be dried using a hot plate or an oven to remove the solvent.

In those cases where the charge transport polymer has a polymerizable functional group, the charge transport polymer can be subjected to a polymerization reaction by performing light irradiation or a heat treatment or the like, thereby changing the degree of solubility of the organic layer. By stacking organic layers having changed degrees of solubility, multilayering of an organic electronic element can be performed with ease. Reference may also be made to WO 2010/140553 in relation to the method used for forming the organic layer.

From the viewpoint of improving the efficiency of charge transport, the thickness of the organic layer obtained following drying or curing is preferably at least 0.1 nm, more preferably at least 1 nm, and even more preferably 3 nm or greater. From the viewpoint of reducing the electrical resistance, the thickness of the organic layer is preferably not more than 300 nm, more preferably not more than 200 nm, and even more preferably 100 nm or less.

### <Organic Electronic Element>

An organic electronic element according to an embodiment of the present invention has at least one or more of the organic layer of the embodiment described above. Examples of the organic electronic element include an organic EL element, an organic photoelectric conversion element, and an organic transistor. The organic electronic element preferably has at least a structure in which an organic layer is disposed between a pair of electrodes.

### <Organic EL Element>

An organic EL element according to an embodiment of the present invention has at least one or more of the organic layer of the embodiment described above. The organic EL element typically includes a light-emitting layer, an anode, a cathode and a substrate, and if necessary, may also have other functional layers such as a hole injection layer, electron injection layer, hole transport layer and electron transport layer. Each layer may be formed by a vapor deposition method or by a coating method. The organic EL element preferably has the organic layer as the light-emitting layer or as another functional layer, more preferably has the organic layer as a functional layer, and even more preferably has the organic layer as at least one of a hole injection layer and a hole transport layer.

FIG. 1 is a cross-sectional schematic view illustrating one embodiment of the organic EL element. The organic EL element in FIG. 1 is an element with a multilayer structure, and has a substrate 8, an anode 2, a hole injection layer 3, a hole transport layer 6, a light-emitting layer 1, an electron transport layer 7, an electron injection layer 5 and a cathode 4 provided in that order. Each of these layers is described below.

### [Light-Emitting Layer]

Examples of the materials that can be used for the light-emitting layer include low-molecular weight compounds, polymers, and dendrimers and the like. Polymers exhibit good solubility in solvents, meaning they are suitable for coating methods, and are consequently preferred. Examples of the light-emitting material include fluorescent materials, phosphorescent materials, and thermally activated delayed fluorescent materials (TADF).

Specific examples of the fluorescent materials include low-molecular weight compounds such as perylene, coumarin, rubrene, quinacridone, stilbene, color laser dyes, aluminum complexes, and derivatives of these compounds; polymers such as polyfluorene, polyphenylene, polyphenylenevinylene, polyvinylcarbazole, fluorene-benzothiadiazole copolymers, fluorenetriphenylamine copolymers, and derivatives of these compounds; and mixtures of the above materials.

Examples of materials that can be used as the phosphorescent materials include metal complexes and the like containing a metal such as Ir or Pt or the like. Specific examples of Ir complexes include FIr(pic) (iridium(III) bis[(4,6-difluorophenyl)-pyridinato-N,C²]picolinate) which emits blue light, Ir(ppy)₃ (fac-tris(2-phenylpyridine)iridium) which emits green light, and (btp)₂Ir(acac) (bis[2-(2'-benzo[4,5-α]thienyl)pyridinato-N,C³]iridium(acetyl-acetonate)) and Ir(piq)₃ (tris(1-phenylisoqionoline)iridium) which emit red light. Specific examples of Pt complexes include PtOEP (2,3,7,8,12,13,17,18-octaethyl-21H,23H-porphyrin-platinum) which emits red light.

When the light-emitting layer contains a phosphorescent material, a host material is preferably also included in addition to the phosphorescent material. Any of low-molecular weight compounds, polymers and dendrimers can be used as this host material. Examples of the low-molecular weight compounds include CBP (4,4'-bis(9H-carbazol-9-yl)-biphenyl), mCP (1,3-bis(9-carbazolyl)benzene), CDBP (4,4'-bis(carbazol-9-yl)-2,2'-dimethylbiphenyl), and derivatives of these compounds, whereas examples of the polymers include the organic electronic material of the embodiment described above, polyvinylcarbazole, polyphenylene, polyfluorene, and derivatives of these polymers.

Examples of the thermally activated delayed fluorescent materials include the compounds disclosed in Adv. Mater., 21, 4802-4906 (2009); Appl. Phys. Lett., 98, 083302 (2011); Chem. Comm., 48, 9580 (2012); Appl. Phys. Lett., 101, 093306 (2012); J. Am. Chem. Soc., 134, 14706 (2012); Chem. Comm., 48, 11392 (2012); Nature, 492, 234 (2012); Adv. Mater., 25, 3319 (2013); J. Phys. Chem. A, 117, 5607 (2013); Phys. Chem. Chem. Phys., 15, 15850 (2013); Chem. Comm., 49, 10385 (2013); and Chem. Lett., 43, 319 (2014) and the like.

### [Hole Injection Layer, Hole Transport Layer]

The organic layer formed using the organic electronic material described above is preferably used as at least one of a hole injection layer and a hole transport layer, and is more preferably used as at least a hole transport layer. As mentioned above, by using an ink composition containing the organic electronic material, these types of layers can be formed with ease.

In those cases where the organic EL element has an organic layer formed using the organic electronic material described above as a hole transport layer, and also has a hole injection layer, a known material may be used for the hole injection layer. In those cases where the organic EL element has an organic layer formed using the organic electronic material described above as a hole injection layer, and also has a hole transport layer, a known material may be used for the hole transport layer.

In those cases where a material including a triphenylamine is used for the hole injection layer, from the viewpoint of the energy level associated with hole transport, the organic electronic material of an embodiment of the present invention is preferably used for the hole transport layer. In particular, in those cases where the hole injection layer contains a polymerization initiator, and a branched polymer having a polymerizable substituent is used as the aforementioned charge transport polymer in the hole transport layer, the hole transport layer can be cured, and therefore a light-emitting layer formed from an ink or the like can be applied as an upper layer on top of the hole transport layer. In this case, a polymerization initiator may be used in the hole injection layer.

### [Electron Transport Layer, Electron Injection Layer]

Examples of materials that can be used for the electron transport layer and the electron injection layer include phenanthroline derivatives, bipyridine derivatives, nitro-substituted fluorene derivatives, diphenylquinone derivatives, thiopyran dioxide derivatives, condensed-ring tetracarboxylic acid anhydrides of naphthalene and perylene and the like, carbodiimides, fluorenylidenemethane derivatives, anthraquinodimethane and anthrone derivatives, oxadiazole derivatives, thiadiazole derivatives, benzimidazole derivatives, quinoxaline derivatives, and aluminum complexes. Further, the organic electronic material of the embodiment described above may also be used.

### [Cathode]

Examples of the cathode material include metals or metal alloys, such as Li, Ca, Mg, Al, In, Cs, Ba, Mg/Ag, LiF and CsF.

### [Anode]

Metals (for example, Au) or other materials having conductivity can be used as the anode material. Examples of the other materials include oxides (for example, ITO: indium oxide/tin oxide), and conductive polymers (for example, polythiophene-polystyrene sulfonate mixtures (PEDOT:PSS)).

### [Substrate]

Glass and plastics and the like can be used as the substrate. The substrate is preferably transparent. A flexible substrate having flexibility is preferred. Quartz glass and light-transmitting resin films and the like can be used particularly favorably.

Light-transmitting resin films are preferred as the resin film. Examples of the resin films include films formed with polyethylene terephthalate, polyethylene naphthalate, polyethersulfone, polyetherimide, polyetheretherketone, polyphenylene sulfide, polyarylate, polyimide, polycarbonate, cellulose triacetate, or cellulose acetate propionate or the like.

In those cases where a resin film is used, an inorganic substance such as silicon oxide or silicon nitride may be coated onto the resin film to inhibit the transmission of water vapor and oxygen and the like.

### [Encapsulation]

The organic EL element may be encapsulated to reduce the effect of the outside atmosphere and extend the lifespan of the element. Materials that can be used for the encapsulation include, but are not limited to, glass, plastic films such as epoxy resins, acrylic resins, polyethylene terephthalate and polyethylene naphthalate, and inorganic substances such as silicon oxide and silicon nitride.

There are no particular limitations on the encapsulation method, and known methods may be used.

### [Emission Color]

There are no particular limitations on the color of the light emission from the organic EL element. White organic EL elements can be used for various illumination fixtures, including domestic lighting, in-vehicle lighting, watches and liquid crystal backlights, and are consequently preferred.

As the method used for forming a white organic EL element involves, a method using a plurality of light-emitting materials to emit a plurality of colors simultaneously, and mixing the emitted colors to obtain a white light emission can be used. There are no particular limitations on the combination of the plurality of emission colors, and examples thereof include combinations that include three maximum emission wavelengths for blue, green and red, and combinations that include two maximum emission wavelengths for blue and yellow, or yellowish green and orange, or the like. Control of the emission color can be achieved by appropriate adjustment of the types and amounts of the light-emitting materials.

### <Display Element, Illumination Device, Display Device>

A display element according to an embodiment of the present invention includes the organic EL element of the embodiment described above. For example, by using the organic EL element as the element corresponding with each color pixel of red, green and blue (RGB), a color display element can be obtained. Examples of the image formation method include a simple matrix in which organic EL elements arrayed in a panel are driven directly by an electrode arranged in a matrix, and an active matrix in which a thin-film transistor is positioned on, and drives, each element.

Further, an illumination device according to an embodiment of the present invention includes the organic EL element of an embodiment of the present invention. Moreover, a display device according to an embodiment of the present invention includes the illumination device and a liquid crystal element as a display unit. For example, the display device may be a device in which the illumination device according to an embodiment of the present invention is used as a backlight, and a conventional liquid crystal element is used as the display unit, namely a liquid crystal display device.

### EXAMPLES

The present invention is described below in further detail using a series of examples, but the present invention is not limited by the following examples. Unless specifically stated otherwise,"%" means "% by mass".

### <Preparation of Pd Catalyst>

In a glove box under a nitrogen atmosphere at room temperature, tris(dibenzylideneacetone)dipalladium (73.2 mg, 80 µmol) was weighed into a sample tube, anisole (15 ml) was added, and the resulting mixture was agitated for 30 minutes. In a similar manner, tris(t-butyl)phosphine (129.6 mg, 640 µmol) was weighed into a sample tube, anisole (5 ml) was added, and the resulting mixture was agitated for 5 minutes. The two solutions were then mixed together and stirred for 30 minutes at room temperature to obtain a catalyst. All the solvents used in the catalyst preparation were deaerated by nitrogen bubbling for at least 30 minutes prior to use.

### <Synthesis of Charge Transport Polymer 1>

A three-neck round-bottom flask was charged with a monomer L2-1 shown below (5.0 mmol), a monomer B-1 shown below (2.0 mmol), a monomer T2-1 shown below (2.0 mmol), a monomer T2-2 shown below (2.0 mmol) and anisole (20 mL), and the prepared Pd catalyst solution (7.5 mL) was also added. After stirring for 30 minutes, a 10% aqueous solution of tetraethylammonium hydroxide (20 mL) was added. All of the solvents were deaerated by nitrogen bubbling for at least 30 minutes prior to use. The resulting mixture was heated and refluxed for 2 hours. All the operations up to this point were conducted under a stream of nitrogen.

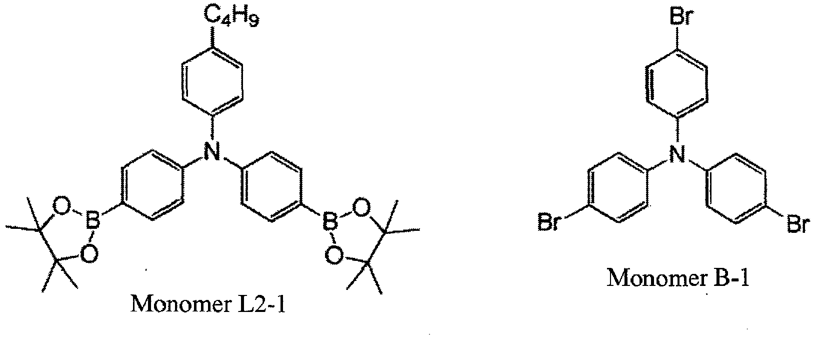

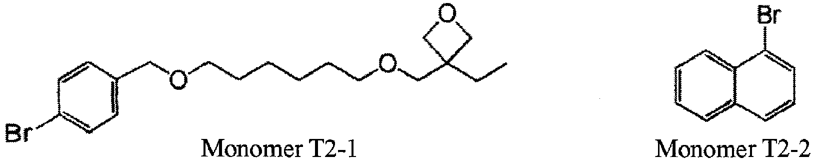

After completion of the reaction, the organic layer was washed with water, and the organic layer was then poured into methanol-water (9:1). The resulting precipitate was collected by filtration under reduced pressure, and washed with methanol-water (9:1). The obtained precipitate was dissolved in toluene, and re-precipitated from methanol. The obtained precipitate was collected by filtration under reduced pressure and then dissolved in toluene, and a metal adsorbent ("Triphenylphosphine, polymer-bound on styrene-divinylbenzene copolymer", manufactured by Strem Chemicals Inc., 200 mg per 100 mg of the precipitate) was then added to the solution and stirred overnight. Following completion of the stirring, the metal adsorbent and other insoluble matter were removed by filtration, and the filtrate was concentrated using a rotary evaporator. The concentrate was dissolved in toluene, and then re-precipitated from methanol-acetone (8:3). The thus produced precipitate was collected by filtration under reduced pressure and washed with methanol-acetone (8:3). The thus obtained precipitate was then dried under vacuum to obtain a charge transport polymer 1.

The thus obtained charge transport polymer 1 had a number average molecular weight of 5,200 and a weight average molecular weight of 41,200. The charge transport polymer 1 had a structural unit L2-1, a structural unit B-1, a structural unit T2-2, and a structural unit T2-1 having an oxetane group, and the proportions (molar ratios) of those structural units were 45.5%, 18.2%, 18.2% and 18.2% respectively.

The number average molecular weight and the mass average molecular weight were measured by GPC (relative to polystyrene standards) using tetrahydrofuran (THF) as the eluent. The measurement conditions were as follows.
Feed pump: L-6050, manufactured by Hitachi High-Technologies Corporation
UV-Vis detector: L-3000, manufactured by Hitachi High-Technologies Corporation
Columns: Gelpack (a registered trademark) GL-A160S / GL-A150S, manufactured by Hitachi Chemical Co., Ltd.
Eluent: THF (for HPLC, stabilizer-free), manufactured by Wako Pure Chemical Industries, Ltd.
Flow rate: 1 mL/min
Column temperature: room temperature
Molecular weight standards: standard polystyrenes

### <Synthesis of Charge Transport Polymer 2>

A three-neck round-bottom flask was charged with the monomer L-1 shown above (5.0 mmol), a monomer B-2 shown below (2.0 mmol), a monomer T1-1 shown below (3.0 mmol), the monomer T2-1 shown above (1.0 mmol) and anisole (20 mL), and the prepared Pd catalyst solution (7.5 mL) was also added. Thereafter, a charge transport polymer 2 was synthesized in the same manner as the synthesis of the charge transport polymer 1.

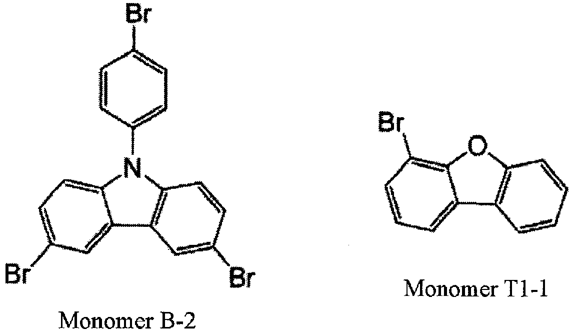

The thus obtained charge transport polymer 2 had a number average molecular weight of 9,600 and a weight average molecular weight of 66,400. The charge transport polymer 2 had a structural unit L-1, a structural unit B-2, a structural unit T1-1, and a structural unit T2-1 having an oxetane group, and the proportions (molar ratios) of those structural units were 45.5%, 18.2%, 27.2% and 9.1% respectively.

### <Synthesis of Charge Transport Polymer 3>

A three-neck round-bottom flask was charged with the monomer L-1 shown above (5.0 mmol), the monomer B-2 shown above (2.0 mmol), a monomer T1-2 shown below (3.0 mmol), the monomer T2-1 shown above (1.0 mmol) and anisole (20 mL), and the prepared Pd catalyst solution (7.5 mL) was also added. Thereafter, a charge transport polymer 3 was synthesized in the same manner as the synthesis of the charge transport polymer 1.

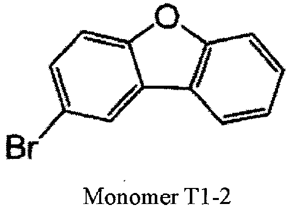

The thus obtained charge transport polymer 3 had a number average molecular weight of 15,600 and a weight average molecular weight of 57,900. The charge transport polymer 3 had a structural unit L-1, a structural unit B-2, a structural unit T1-2, and a structural unit T2-1 having an oxetane group, and the proportions (molar ratios) of those structural units were 45.5%, 18.2%, 27.2% and 9.1% respectively.

### <Synthesis of Charge Transport Polymer 4>

A three-neck round-bottom flask was charged with the monomer L-1 shown above (5.0 mmol), the monomer B-2 shown above (2.0 mmol), a monomer T1-3 shown below (3.0 mmol), the monomer T2-1 shown above (1.0 mmol) and anisole (20 mL), and the prepared Pd catalyst solution (7.5 mL) was also added. Thereafter, a charge transport polymer 4 was synthesized in the same manner as the synthesis of the charge transport polymer 1.

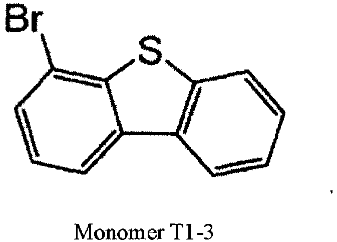

The thus obtained charge transport polymer 4 had a number average molecular weight of 16,600 and a weight average molecular weight of 71,100. The charge transport polymer 4 had a structural unit L-1, a structural unit B-2, a structural unit T1-3, and a structural unit T2-1 having an oxetane group, and the proportions (molar ratios) of those structural units were 45.5%, 18.2%, 27.2% and 9.1% respectively.

### <Synthesis of Charge Transport Polymer 5>

A three-neck round-bottom flask was charged with the monomer L-1 shown above (5.0 mmol), the monomer B-2 shown above (2.0 mmol), a monomer T1-4 shown below (3.0 mmol), the monomer T2-1 shown above (1.0 mmol) and anisole (20 mL), and the prepared Pd catalyst solution (7.5 mL) was also added. Thereafter, a charge transport polymer 5 was synthesized in the same manner as the synthesis of the charge transport polymer 1.

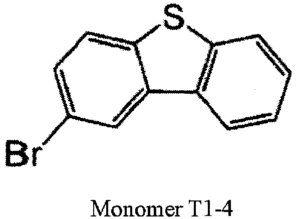

The thus obtained charge transport polymer 5 had a number average molecular weight of 13,500 and a weight average molecular weight of 60,000. The charge transport polymer 5 had a structural unit L-1, a structural unit B-2, a structural unit T1-4, and a structural unit T2-1 having an oxetane group, and the proportions (molar ratios) of those structural units were 45.5%, 18.2%, 27.2% and 9.1% respectively.

### <Synthesis of Charge Transport Polymer 6>

Prior to synthesis of the charge transport polymer 6, a monomer T1-5 was synthesized.

### (Synthesis of Monomer T1-5)

Under a nitrogen atmosphere, a two-neck round-bottom flask was charged with 3.7 g (10 mmol) of 2-bromo-8-iododibenzofuran, 1.7 g (10 mmol) of carbazole, 4.2 g (20 mmol) of potassium phosphate, 0.19 g (1 mmol) of copper iodide, 0.23 g (2 mmol) of 1,2-cyclohexanediamine and dioxane (20 ml), and the resulting mixture was stirred under heating at 100°C for 12 hours. After cooling, water was added, the organic layer was separated, and the solvent was removed from the separated organic layer by distillation. The resulting crude product was purified by silica gel column chromatography using a mixed solvent of ethyl acetate and hexane, and was then recrystallized from a toluene/hexane mixed solvent, thus obtaining the targeted monomer T1-5 as a white solid (2.9 g, yield: 70%).

### <Synthesis of Charge Transport Polymer 6>

A three-neck round-bottom flask was charged with the monomer L-1 shown above (5.0 mmol), the monomer B-2 shown above (2.0 mmol), the prepared monomer T1-5 shown below (3.0 mmol), the monomer T2-1 shown above (1.0 mmol) and anisole (20 mL), and the prepared Pd catalyst solution (7.5 mL) was also added. Thereafter, a charge transport polymer 6 was synthesized in the same manner as the synthesis of the charge transport polymer 1.

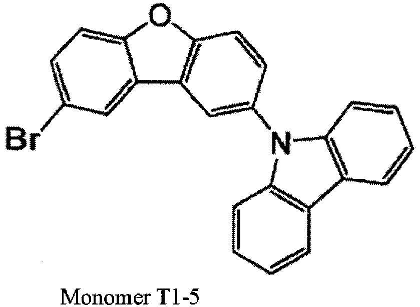

The thus obtained charge transport polymer 6 had a number average molecular weight of 13,000 and a weight average molecular weight of 62,600. The charge transport polymer 6 had a structural unit L-1, a structural unit B-2, a structural unit T1-5, and a structural unit T2-1 having an oxetane group, and the proportions (molar ratios) of those structural units were 45.5%, 18.2%, 27.2% and 9.1% respectively.

### <Synthesis of Charge Transport Polymer 7>

A three-neck round-bottom flask was charged with the monomer L-1 shown above (5.0 mmol), the monomer B-2 shown above (2.0 mmol), a monomer T2-3 shown below (3.0 mmol), the monomer T2-1 shown above (1.0 mmol) and anisole (20 mL), and the prepared Pd catalyst solution (7.5 mL) was also added. Thereafter, a charge transport polymer 7 was synthesized in the same manner as the synthesis of the charge transport polymer 1.

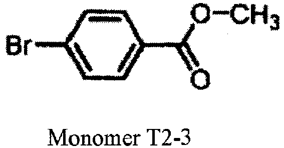

The thus obtained charge transport polymer 7 had a number average molecular weight of 15,300 and a weight average molecular weight of 112,600. The charge transport polymer 7 had a structural unit L-1, a structural unit B-2, a structural unit T2-3, and a structural unit T2-1 having an oxetane group, and the proportions (molar ratios) of those structural units were 45.5%, 18.2%, 27.2% and 9.1% respectively.

### <Synthesis of Charge Transport Polymer 8>

A three-neck round-bottom flask was charged with the monomer L-1 shown above (5.0 mmol), the monomer B-2 shown above (2.0 mmol), a monomer T2-4 shown below (3.0 mmol), the monomer T2-1 shown above (1.0 mmol) and anisole (20 mL), and the prepared Pd catalyst solution (7.5 mL) was also added. Thereafter, a charge transport polymer 8 was synthesized in the same manner as the synthesis of the charge transport polymer 1.

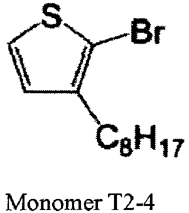

The thus obtained charge transport polymer 8 had a number average molecular weight of 14,500 and a weight average molecular weight of 53,900. The charge transport polymer 8 had a structural unit L-1, a structural unit B-2, a structural unit T2-4 containing a thiophene structure, and a structural unit T2-1 having an oxetane group, and the proportions (molar ratios) of those structural units were 45.5%, 18.2%, 27.2% and 9.1% respectively.

### <Synthesis of Charge Transport Polymer 9>

A three-neck round-bottom flask was charged with the monomer L2-1 shown above (5.0 mmol), a monomer B-2 shown below (2.0 mmol), a monomer T2-5 shown below (3.0 mmol), the monomer T2-1 shown above (1.0 mmol) and anisole (20 mL), and the prepared Pd catalyst solution (7.5 mL) was also added. Thereafter, a charge transport polymer 9 was synthesized in the same manner as the synthesis of the charge transport polymer 1.

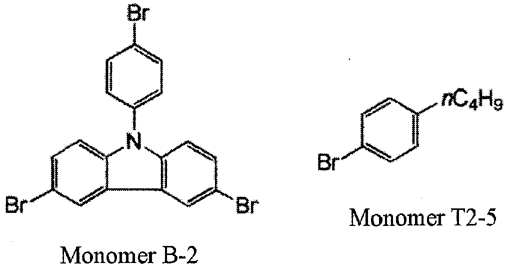

The thus obtained charge transport polymer 9 had a number average molecular weight of 9,600 and a weight average molecular weight of 66,400. The charge transport polymer 9 had a structural unit L2-1, a structural unit B-2, a structural unit T2-3, and a structural unit T2-1 having an oxetane group, and the proportions (molar ratios) of those structural units were 45.5%, 18.2%, 27.3% and 9.1% respectively.

### <Synthesis of Charge Transport Polymer 10>

A three-neck round-bottom flask was charged with the monomer L2-1 shown above (2.5 mmol), a monomer L1-1 shown below (2.5 mmol), the monomer B-2 shown above (2.0 mmol), the monomer T2-3 shown above (3.0 mmol), the monomer T2-1 shown above (1.0 mmol) and anisole (20 mL), and the prepared Pd catalyst solution (7.5 mL) was also added. Thereafter, a charge transport polymer 10 was synthesized in the same manner as the synthesis of the charge transport polymer 1.

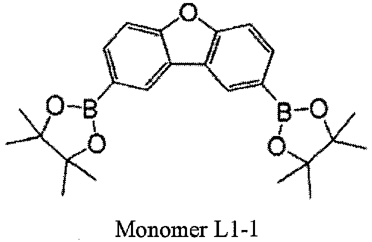

The thus obtained charge transport polymer 10 had a number average molecular weight of 14,600 and a weight average molecular weight of 54,900. The charge transport polymer 10 had a structural unit L2-1, a structural unit L1-1, a structural unit B-2, a structural unit T2-3, and a structural unit T2-1 having an oxetane group, and the proportions (molar ratios) of those structural units were 22.8%, 22.8%, 18.2%, 27.3% and 9.1% respectively.

### <Synthesis of Charge Transport Polymer 11>

A three-neck round-bottom flask was charged with the monomer L2-1 shown above (2.5 mmol), a monomer L1-2 shown below (2.5 mmol), the monomer B-2 shown above (2.0 mmol), the monomer T2-3 shown above (3.0 mmol), the monomer T2-1 shown above (1.0 mmol) and anisole (20 mL), and the prepared Pd catalyst solution (7.5 mL) was also added. Thereafter, a charge transport polymer 11 was synthesized in the same manner as the synthesis of the charge transport polymer 1.

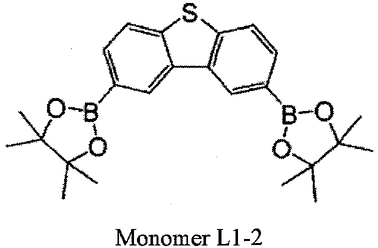

The thus obtained charge transport polymer 11 had a number average molecular weight of 15,600 and a weight average molecular weight of 61,100. The charge transport polymer 11 had a structural unit L2-1, a structural unit L1-2, a structural unit B-2, a structural unit T2-3, and a structural unit T2-1 having an oxetane group, and the proportions (molar ratios) of those structural units were 22.8%, 22.8%, 18.2%, 27.3% and 9.1% respectively.

### <Synthesis of Charge Transport Polymer 12>

A three-neck round-bottom flask was charged with the monomer L2-1 shown above (2.5 mmol), a monomer L1-3 shown below (2.5 mmol), the monomer B-2 shown above (2.0 mmol), the monomer T2-3 shown above (3.0 mmol), the monomer T2-1 shown above (1.0 mmol) and anisole (20 mL), and the prepared Pd catalyst solution (7.5 mL) was also added. Thereafter, a charge transport polymer 12 was synthesized in the same manner as the synthesis of the charge transport polymer 1.

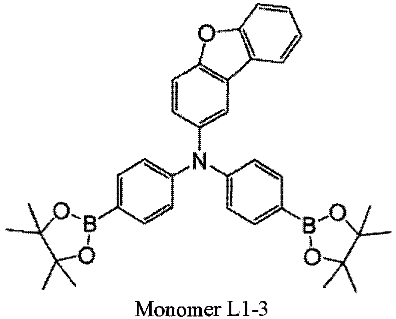

The thus obtained charge transport polymer 12 had a number average molecular weight of 17,100 and a weight average molecular weight of 72,100. The charge transport polymer 12 had a structural unit L2-1, a structural unit LI-3, a structural unit B-2, a structural unit T2-3, and a structural unit T2-1 having an oxetane group, and the proportions (molar ratios) of those structural units were 22.8%, 22.8%, 18.2%, 27.3% and 9.1% respectively.

### <Synthesis of Charge Transport Polymer 13>

A three-neck round-bottom flask was charged with the monomer L2-1 shown above (2.5 mmol), a monomer L1-4 shown below (2.5 mmol), the monomer B-2 shown above (2.0 mmol), the monomer T2-3 shown above (3.0 mmol), the monomer T2-1 shown above (1.0 mmol) and anisole (20 mL), and the prepared Pd catalyst solution (7.5 mL) was also added. Thereafter, a charge transport polymer 13 was synthesized in the same manner as the synthesis of the charge transport polymer 1.

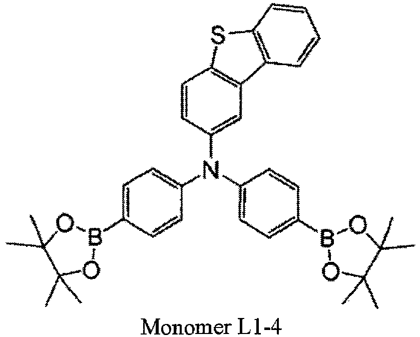

The thus obtained charge transport polymer 13 had a number average molecular weight of 16,800 and a weight average molecular weight of 73,400. The charge transport polymer 13 had a structural unit L2-1, a structural unit LI-4, a structural unit B-2, a structural unit T2-3, and a structural unit T2-1 having an oxetane group, and the proportions (molar ratios) of those structural units were 22.8%, 22.8%, 18.2%, 27.3% and 9.1% respectively.

### <Synthesis of Charge Transport Polymer 14>

A three-neck round-bottom flask was charged with the monomer L2-1 shown above (2.5 mmol), a monomer L1-5 shown below (2.5 mmol), the monomer B-2 shown above (2.0 mmol), the monomer T2-3 shown above (3.0 mmol), the monomer T2-1 shown above (1.0 mmol) and anisole (20 mL), and the prepared Pd catalyst solution (7.5 mL) was also added. Thereafter, a charge transport polymer 14 was synthesized in the same manner as the synthesis of the charge transport polymer 1.

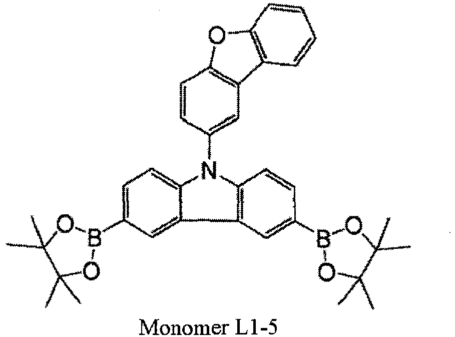

The thus obtained charge transport polymer 14 had a number average molecular weight of 12,700 and a weight average molecular weight of 41,100. The charge transport polymer 14 had a structural unit L2-1, a structural unit LI-5, a structural unit B-2, a structural unit T2-3, and a structural unit T2-1 having an oxetane group, and the proportions (molar ratios) of those structural units were 22.8%, 22.8%, 18.2%, 27.3% and 9.1% respectively.

### <Production of Elements for Evaluating Charge Transportability>

### [Examples 1 to 5 and Comparative Examples 1 and 2, and Examples 11 to 15 and Comparative Example 11]

An ink composition for forming a hole injection layer was prepared under a nitrogen atmosphere by mixing the charge transport polymer 1 (10.0 mg), an electron-accepting compound 1 shown below (0.5 mg) and toluene (2.3 mL). This ink composition was spin-coated at a rotational rate of 3,000 min⁻¹ onto a glass substrate on which ITO had been patterned with a width of 1.6 mm, and the ink composition was then cured by heating at 220°C for 10 minutes on a hot plate, thus forming a hole injection layer (25 nm).

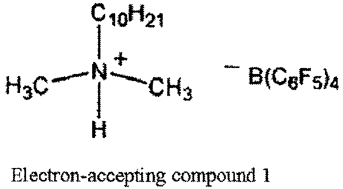

Next, one of the charge transport polymers 2 to 14 (10.0 mg) shown in Table 1A or Table 1B and toluene (1.15 mL) were mixed to prepare an ink composition for forming a hole transport layer. This ink composition was spin-coated at a rotational rate of 3,000 min⁻¹ onto the hole injection layer formed above, and was then cured by heating at 200°C for 10 minutes on a hot plate, thus forming a hole transport layer (40 nm). In each example and each comparative example, the hole transport layer was able to be formed without dissolving the hole injection layer.

The substrate obtained in the manner described above was transferred into a vacuum deposition apparatus, Al (100 nm) was deposited onto the hole transport layer using a vapor deposition method, and an encapsulation treatment was then performed to complete production of an element for evaluating the charge transportability.

A voltage was applied to each of these charge transportability evaluation elements, using the ITO as the anode and the aluminum as the cathode. The applied voltage when the current density was 50 mA/cm² is shown in Table 1A or Table 1B.

**[Table 1A]**

| | Hole injection layer | Hole transport layer | Charge transportability |
|---|---|---|---|
| | | | Applied voltage (V) |
| Example 1 | Charge transport polymer 1 | Charge transport polymer 2 | 1.5 |
| | Electron-accepting compound 1 | | |
| Example 2 | Charge transport polymer 1 | Charge transport polymer 3 | 1.4 |
| | Electron-accepting compound 1 | | |
| Example 3 | Charge transport polymer 1 | Charge transport polymer 4 | 1.6 |
| | Electron-accepting compound 1 | | |
| Example 4 | Charge transport polymer 1 | Charge transport polymer 5 | 1.5 |
| | Electron-accepting compound 1 | | |
| Example 5 | Charge transport polymer 1 | Charge transport polymer 6 | 1.3 |
| | Electron-accepting compound 1 | | |
| Comparative Example 1 | Charge transport polymer 1 | Charge transport polymer 7 | 2.5 |
| | Electron-accepting compound 1 | | |
| Comparative Example 2 | Charge transport polymer 1 | Charge transport polymer 8 | 2.7 |
| | Electron-accepting compound 1 | | |

**[Table 1B]**

| | Hole injection layer | Hole transport layer | Charge transportability |
|---|---|---|---|
| | | | Applied voltage (V) |
| Example 11 | Charge transport polymer 1 | Charge transport polymer 10 | 1.5 |
| | Electron-accepting compound 1 | | |
| Example 12 | Charge transport polymer 1 | Charge transport polymer 11 | 1.4 |
| | Electron-accepting compound 1 | | |
| Example 13 | Charge transport polymer 1 | Charge transport polymer 12 | 1.5 |
| | Electron-accepting compound 1 | | |
| Example 14 | Charge transport polymer 1 | Charge transport polymer 13 | 1.5 |
| | Electron-accepting compound 1 | | |
| Example 15 | Charge transport polymer 1 | Charge transport polymer 14 | 1.7 |
| | Electron-accepting compound 1 | | |
| Comparative Example 11 | Charge transport polymer 1 | Charge transport polymer 9 | 1.8 |
| | Electron-accepting compound 1 | | |

### <Production of Organic EL Elements>

### [Examples 6 to 10 and Comparative Examples 3 and 4, and Examples 16 to 20 and Comparative Example 12]

An ink composition for forming a hole injection layer was prepared under a nitrogen atmosphere by mixing the charge transport polymer 1 (10.0 mg), the electron-accepting compound 1 shown below (0.5 mg) and toluene (2.3 mL). This ink composition was spin-coated at a rotational rate of 3,000 min⁻¹ onto a glass substrate on which ITO had been patterned with a width of 1.6 mm, and the ink composition was then cured by heating at 220°C for 10 minutes on a hot plate, thus forming a hole injection layer (25 nm).

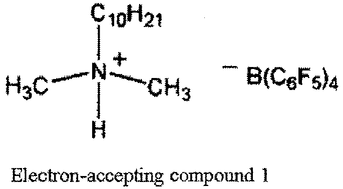

Next, one of the charge transport polymers 2 to 14 (10.0 mg) shown in Table 2A or Table 2B and toluene (1.15 mL) were mixed to prepare an ink composition for forming a hole transport layer. This ink composition was spin-coated at a rotational rate of 3,000 min⁻¹ onto the hole injection layer formed above, and was then cured by heating at 200°C for 10 minutes on a hot plate, thus forming a hole transport layer (40 nm). In each example and each comparative example, the hole transport layer was able to be formed without dissolving the hole injection layer.

**[Table 2A]**

| | Hole Injection Layer | Hole transport layer |
|---|---|---|
| Example 6 | Charge transport polymer 1 | Charge transport polymer 2 |
| | Electron-accepting compound 1 | |
| Example 7 | Charge transport polymer 1 | Charge transport polymer 3 |
| | Electron-accepting compound 1 | |
| Example 8 | Charge transport polymer 1 | Charge transport polymer 4 |
| | Electron-accepting compound 1 | |
| Example 9 | Charge transport polymer 1 | Charge transport polymer 5 |
| | Electron-accepting compound 1 | |
| Example 10 | Charge transport polymer 1 | Charge transport polymer 6 |
| | Electron-accepting compound 1 | |
| Comparative Example 3 | Charge transport polymer 1 | Charge transport polymer 7 |
| | Electron-accepting compound 1 | |
| Comparative Example 4 | Charge transport polymer 1 | Charge transport polymer 8 |
| | Electron-accepting compound 1 | |

**[Table 2B]**

| | Hole Injection Layer | Hole transport layer |
|---|---|---|
| Example 16 | Charge transport polymer 1 | Charge transport polymer 10 |
| | Electron-accepting compound 1 | |
| Example 17 | Charge transport polymer 1 | Charge transport polymer 11 |
| | Electron-accepting compound 1 | |
| Example 18 | Charge transport polymer 1 | Charge transport polymer 12 |
| | Electron-accepting compound 1 | |
| Example 19 | Charge transport polymer 1 | Charge transport polymer 13 |
| | Electron-accepting compound 1 | |
| Example 20 | Charge transport polymer 1 | Charge transport polymer 14 |
| | Electron-accepting compound 1 | |
| Comparative Example 12 | Charge transport polymer 1 | Charge transport polymer 9 |
| | Electron-accepting compound 1 | |

Each of the substrates obtained above was transferred into a vacuum deposition apparatus, layers of CBP:Ir(ppy)₃ (94:6, 30 nm), BAlq (10 nm), TPBi (30 nm), LiF (0.8 nm) and Al (100 nm) were deposited in that order using vapor deposition methods on top of the hole transport layer, and an encapsulation treatment was then performed to complete production of an organic EL element.

When a voltage was applied to each of the organic EL elements obtained in Examples 6 to 10 and Comparative Examples 3 and 4, and Examples 16 to 20 and Comparative Example 12, green light emission was confirmed in each case. For each element, the emission efficiency at an emission luminance of 1,000 cd/m², the drive voltage, and the emission lifespan (luminance half-life) when the initial luminance was 5,000 cd/m² were measured.

The measurement results are shown in Table 3A and Table 3B.

**[Table 3A]**

| | Emission efficiency (cd/A) | Drive voltage (V) | Emission lifespan (h) |
|---|---|---|---|
| Example 6 | 40.2 | 6.5 | 250.1 |
| Example 7 | 37.6 | 6.2 | 240.5 |
| Example 8 | 38.9 | 6.6 | 245.9 |
| Example 9 | 37.9 | 6.6 | 247.3 |
| Example 10 | 39.5 | 6.1 | 249.3 |
| Comparative Example 3 | 34.3 | 8.2 | 98.3 |
| Comparative Example 4 | 32.2 | 8.3 | 87.4 |

**[Table 3B]**

| | Emission efficiency (cd/A) | Drive voltage (V) | Emission lifespan (h) |
|---|---|---|---|
| Example 16 | 40.2 | 6.5 | 262.1 |
| Example 17 | 37.6 | 6.2 | 254.5 |
| Example 18 | 38.9 | 6.6 | 249.4 |
| Example 19 | 37.9 | 6.6 | 244.3 |
| Example 20 | 41.5 | 7.2 | 230.3 |
| Comparative Example 12 | 34.3 | 8.2 | 150.3 |

As shown in Table 3A and Table 3B, comparison of Examples 6 to 10 with Comparative Examples 3 and 4, and comparison of Examples 16 to 20 with Comparative Example 12, revealed that by using the organic electronic material according to an embodiment of the present invention in a hole transport layer, a long-life element having high emission efficiency, a low drive voltage and superior drive stability could be obtained.

### <Production of White Organic EL Element (Illumination Device)>

### [Example 21]

An ink composition for forming a hole injection layer was prepared under a nitrogen atmosphere by mixing the charge transport polymer 1 (10.0 mg), the electron-accepting compound 1 shown above (0.5 mg) and toluene (2.3 mL). This ink composition was spin-coated at a rotational rate of 3,000 min⁻¹ onto a glass substrate on which ITO had been patterned with a width of 1.6 mm, and the ink composition was then cured by heating at 220°C for 10 minutes on a hot plate, thus forming a hole injection layer (25 nm).

The charge transport polymer 2 (20 mg) and toluene (1.15 mL) were mixed to prepare an ink composition for forming a hole transport layer. This ink composition was spin-coated at a rotational rate of 3,000 min⁻¹ onto the hole injection layer, and was then cured by heating at 200°C for 10 minutes on a hot plate, thus forming a hole transport layer (40 nm). The hole transport layer was able to be formed without dissolving the hole injection layer.

An ink composition for forming a light-emitting layer was prepared by mixing CDBP (15 mg), FIr(pic) (0.9 mg), Ir(ppy)₃ (0.9 mg), (btp)₂Ir(acac) (1.2 mg) and dichlorobenzene (0.5 mL) in a nitrogen atmosphere. This ink composition was spin-coated at a rotational rate of 3,000 min⁻¹ onto the hole transport layer, and was then dried by heating at 80°C for 5 minutes on a hot plate, thus forming a light-emitting layer (40 nm). The light-emitting layer was able to be formed without dissolving the hole transport layer.

The glass substrate having the hole injection layer, the hole transport layer and the light-emitting layer stacked in that order was transferred into a vacuum deposition apparatus, and layers of BAlq (10 nm), TPBi (30 nm), LiF (0.5 nm) and Al (100 nm) were deposited in that order using vapor deposition methods on top of the light-emitting layer. Subsequently, an encapsulation treatment was performed to complete production of a white organic EL element. The thus obtained white organic EL element was able to be used as an illumination device.

### [Example 22]

With the exception of replacing the charge transport polymer 2 from Example 21 with the charge transport polymer 10, a white organic EL element was produced in the same manner as Example 21. The obtained white organic EL element was able to be used as an illumination device.

### [Comparative Example 5]

With the exception of replacing the charge transport polymer 2 with the charge transport polymer 7, a white organic EL element was produced in the same manner as Example 21. The light-emitting layer was able to be formed without dissolving the hole transport layer. Further, the white organic EL element was able to be used as an illumination device.

A voltage was applied to each of the white organic EL elements obtained in Example 21 and Comparative Example 5, and the emission lifespan (luminance half-life) when the initial luminance was 1,000 cd/m² was measured. When the emission lifespan in Example 21 was deemed to be 1, the result for Comparative Example 5 was 0.17. Further, when the voltage at a luminance of 1,000 cd/m² in Example 21 was deemed to be 1, the result for Comparative Example 5 was 1.13.

The white organic EL element of Example 21 exhibited an excellent emission lifespan and drive voltage.

### [Comparative Example 13]

With the exception of replacing the charge transport polymer 2 with the charge transport polymer 9, a white organic EL element was produced in the same manner as Example 21. The light-emitting layer was able to be formed without dissolving the hole transport layer. Further, the white organic EL element was able to be used as an illumination device.

A voltage was applied to each of the white organic EL elements obtained in Example 22 and Comparative Example 13, and the emission lifespan (luminance half-life) when the initial luminance was 1,000 cd/m² was measured. When the emission lifespan in Example 22 was deemed to be 1, the result for Comparative Example 13 was 0.7. Further, when the voltage at a luminance of 1,000 cd/m² in Example 22 was deemed to be 1, the result for Comparative Example 13 was 1.1.

The white organic EL element of Example 22 exhibited an excellent emission lifespan and drive voltage.

Effects of the embodiments of the present invention have been demonstrated above using a series of examples. In addition to the charge transport polymers used in the above examples, other charge transport polymers having at least one structural unit containing the substituted or unsubstituted dibenzofuran structure or dibenzothiophene structure described above can also be used to obtain organic EL elements having a long lifespan, and similar superior effects can be achieved.

### DESCRIPTION OF THE REFERENCE SIGNS

- 1:: Light-emitting layer
- 2:: Anode
- 3:: Hole injection layer
- 4:: Cathode
- 5:: Electron injection layer
- 6:: Hole transport layer
- 7:: Electron transport layer
- 8:: Substrate

## Claims

1. An organic electronic material comprising a charge transport polymer or oligomer having at least one structural unit containing a substituted or unsubstituted dibenzofuran structure or dibenzothiophene structure.

2. The organic electronic material according to Claim 1, comprising a charge transport polymer or oligomer having a structural unit represented by a formula (1) shown below at at least one terminal: 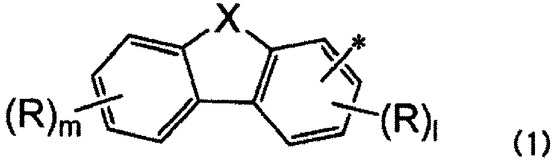 wherein, in formula (1), X represents an oxygen atom or a sulfur atom, each R independently represents a substituent, 1 represents an integer of 0 to 3, m represents an integer of 0 to 4, and * indicates a bonding site with another structural unit.

3. The organic electronic material according to Claim 2, wherein the charge transport polymer or oligomer has three or more terminals.

4. The organic electronic material according to Claim 2 or 3, wherein the charge transport polymer or oligomer has a structural unit represented by the formula (1) at 25% or more of all terminals based on a total number of terminals.

5. The organic electronic material according to any one of Claims 2 to 4, wherein the charge transport polymer or oligomer is a copolymer of a monomer containing a structural unit having hole transport properties, and a monomer containing a structural unit represented by the formula (1).

6. The organic electronic material according to Claim 1, wherein the charge transport polymer or oligomer has at least one structural unit selected from the group consisting of a divalent structural unit L1 having a substituted or unsubstituted dibenzofuran structure or dibenzothiophene structure.

7. The organic electronic material according to Claim 6, wherein the divalent structural unit L1 has at least one structure selected from among a structure represented by formula L1a, a structure represented by formula L1b and a structure represented by formula L1c shown below: 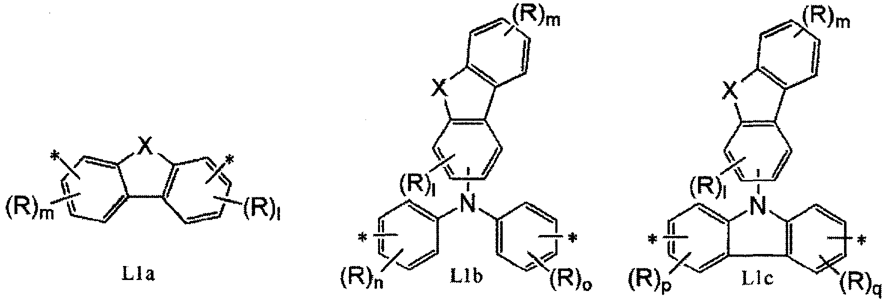 wherein, in the formulae, X represents an oxygen atom or a sulfur atom, each R independently represents a hydrogen atom or a substituent, each R is independently selected from the group consisting of -R¹, -OR², -SR³, -OCOR⁴, -COOR⁵, -SiR⁶R⁷R⁸, a halogen atom, and a group containing a polymerizable functional group described below, each of R¹ to R⁸ independently represents a hydrogen atom, a linear, cyclic or branched alkyl group, alkenyl group, alkynyl group or alkoxy group of 1 to 22 carbon atoms, an aryl group or heteroaryl group of 2 to 30 carbon atoms, or a polymerizable functional group, each of 1, m, p and q independently represents an integer of 0 to 3, each of n and o independently represents an integer of 0 to 4, and "*" in formula (1) indicates a bonding site with another structural unit.

8. The organic electronic material according to Claim 6 or 7, wherein the charge transport polymer also has at least one selected from the group consisting of a divalent structural unit L2 that does not contain a dibenzofuran structure or dibenzothiophene structure.

9. The organic electronic material according to any one of Claims 6 to 8, wherein the charge transport polymer also has a divalent structural unit L2 that does not contain a dibenzofuran structure or dibenzothiophene structure, and the divalent structural unit L2 contains a structure selected from the group consisting of an aromatic amine structure, a carbazole structure, a thiophene structure, a bithiophene structure, a benzene structure and a fluorene structure.

10. The organic electronic material according to any one of Claims 1 to 9, wherein the charge transport polymer has a structure that is branched in three or more directions.

11. The organic electronic material according to any one of Claims 1 to 10, wherein the charge transport polymer has a polymerizable substituent.

12. An ink composition comprising the organic electronic material according to any one of Claims 1 to 11, and a solvent.

13. An organic layer formed using the organic electronic material according to any one of Claims 1 to 11, or the ink composition according to Claim 12.

14. An organic electronic element comprising at least one of the organic layer according to Claim 13.

15. An organic electroluminescent element comprising at least one of the organic layer according to Claim 13.

16. The organic electroluminescent element according to Claim 15, further comprising a flexible substrate.

17. The organic electroluminescent element according to Claim 15, further comprising a resin film substrate.

18. A display element comprising the organic electroluminescent element according to any one of Claims 15 to 17.

19. An illumination device comprising the organic electroluminescent element according to any one of Claims 15 to 17.

20. A display device comprising the illumination device according to Claim 19, and a liquid crystal element as a display unit.
